(19) Europäisches Patentamt
European Patent Office
Office européen des brevets

(11) **EP 3 221 710 B1**

(12) **FASCICULE DE BREVET EUROPEEN**

(45) Date de publication et mention
de la délivrance du brevet:
**10.10.2018 Bulletin 2018/41**

(21) Numéro de dépôt: **15794576.7**

(22) Date de dépôt: **13.11.2015**

(51) Int Cl.:
***G01R 31/36*** *(2006.01)*

(86) Numéro de dépôt international:
**PCT/EP2015/076594**

(87) Numéro de publication internationale:
**WO 2016/079026 (26.05.2016 Gazette 2016/21)**

(54) **PROCEDE DE CARACTERISATION D'UN ACCUMULATEUR**

VERFAHREN ZUR CHARAKTERISIERUNG EINES AKKUMULATORS

METHOD FOR CHARACTERISING AN ACCUMULATOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **17.11.2014 FR 1461051**

(43) Date de publication de la demande:
**27.09.2017 Bulletin 2017/39**

(73) Titulaire: **Commissariat à l'Énergie Atomique
et aux Énergies Alternatives
75015 Paris (FR)**

(72) Inventeurs:
• **KRUGER, Eiko
F-73000 Chambery (FR)**
• **MAMADOU, Kelli
F-97200 Fort de France (FR)**

(74) Mandataire: **Novaimo
ActiTech 8
60 avenue Marie Curie
Archamps Technopole
74166 Saint Julien-en-Genevois Cedex (FR)**

(56) Documents cités:
**WO-A1-2011/000872      WO-A1-2013/175005
US-A1- 2011 029 193      US-A1- 2013 311 119
US-A1- 2014 139 189**

**Description**

L'invention concerne un procédé de caractérisation d'un accumulateur électrochimique, ainsi qu'un procédé d'estimation de l'énergie disponible au sein d'un tel accumulateur. Elle concerne aussi tout dispositif ou système intégrant un accumulateur électrochimique dont la gestion est basée sur ce procédé de caractérisation.

Pour maîtriser le fonctionnement de tout appareil ou système intégrant au moins un accumulateur électrochimique, il est essentiel de connaître et maîtriser les performances d'un tel accumulateur, pour notamment gérer ses phases de charge et décharge et au final optimiser le fonctionnement de l'appareil ou du système. Il est en effet avantageux de connaître à tout instant l'état de l'accumulateur et de pouvoir prévoir si sa réserve énergétique est suffisante pour fournir une énergie demandée. Cela exige donc la connaissance de l'énergie disponible de manière dynamique.

Une approche traditionnelle de l'état de la technique consiste d'une part à étudier le courant que peut fournir l'accumulateur, et d'autre part à estimer de manière découplée sa tension de sortie, pour en déduire sa puissance par le produit du courant et de la tension.

Dans cette approche traditionnelle, la loi de Peukert est appliquée, permettant de déterminer la capacité $C_{td\_mes}$ en Ampère-heure de l'accumulateur, qui correspond à la quantité de charge susceptible d'être fournie pendant un temps $t_{d\_mes}$ jusqu'à sa complète décharge, en fonction du courant constant de décharge imposé $I_{d\_imp}$, de la durée de décharge $t_{d\_mes}$ mesurée, en fonction d'une constante K et du coefficient de Peukert n, selon la relation suivante :

$$C_{td\_mes} = t_{d\_mes} \times I_{d\_imp} = K / (I_{d\_imp})^{n-1}$$

Ensuite, cette approche traditionnelle est complétée par l'estimation de l'état de charge de l'accumulateur, appelé par sa dénomination anglo-saxonne « State Of Charge », et couramment plus simplement SOC. Ce paramètre de SOC représente la capacité disponible de l'accumulateur sur une échelle de 0 à 100%. La valeur de SOC est établie et connue pour différents régimes de décharge imposés, tout au long de la vie de l'accumulateur. Pour cela, des algorithmes itératifs sont basés sur la loi de Peukert, adaptée pour tenir compte de différents facteurs comme le vieillissement de l'accumulateur et la température. Cette approche est en pratique très difficile et imprécise car de nombreux facteurs influencent le SOC. De plus, le coefficient de Peukert n nécessite aussi une grande précision, de l'ordre de $10^{-3}$, pour approcher des résultats satisfaisants, ce qui exige des expérimentations complexes et très précises. En parallèle, il est nécessaire de prédire les variations de la tension dans le temps aux bornes de l'accumulateur. Cette estimation est réalisée par calcul à l'aide d'un modèle. Enfin, le produit du courant de décharge par la tension permet d'atteindre la puissance de décharge de l'accumulateur, dont l'intégration dans le temps permet d'en déduire l'énergie disponible.

Pour palier les inconvénients de l'approche traditionnelle décrite ci-dessus, le document WO2011000872 décrit un procédé de calibration d'un accumulateur qui repose sur la détermination de plusieurs triplets de données ($SOE_{0i}$ ; $P_{di}$ ; $e_{di}$), chaque triplet associant un état d'énergie initial $SOE_{0i}$, une puissance de décharge $P_{di}$ et une énergie disponible $e_{di}$, où l'index i parcourt le nombre de triplets d'une caractérisation en décharge $n_{dmes}$. Un tel triplet de valeurs présente ensuite l'intérêt, lors de l'utilisation d'un accumulateur, de pouvoir connaître son énergie disponible s'il se trouve à l'état d'énergie initial $SOE_{0i}$ et si on souhaite l'utiliser à la puissance de décharge $P_{di}$. De manière similaire, il est aussi déterminé des triplets de données ($SOE_{0j}$ ; $P_{ci}$ ; $a_{ri}$) associant un état d'énergie initial $SOE_{0i}$, une puissance de charge $P_{ci}$ et une énergie recevable $a_{ri}$. Un tel triplet de valeurs présente ensuite l'intérêt, lors de la charge d'un accumulateur, de pouvoir connaître l'énergie qu'il peut recevoir s'il se trouve à l'état d'énergie initial $SOE_{0i}$ et si on souhaite le charger à la puissance de charge $P_{ci}$.

En pratique, un accumulateur subit d'abord une phase de calibration, qui permet de mesurer directement et de mémoriser un nombre choisi de triplets de données tels que mentionnés ci-dessus. Des méthodes de calcul mathématique, à base d'interpolations, permettent ensuite d'estimer les triplets intermédiaires non directement mesurés lors de la phase de calibration. Il en ressort une connaissance de tous ces triplets de données, ce qui est ensuite utilisé lors d'une seconde phase d'utilisation de l'accumulateur dans un système, pour gérer au mieux les périodes de décharge durant lesquelles il restitue de l'énergie et pour les périodes de charge durant lesquelles il reçoit de l'énergie.

Une phase de calibration selon l'approche explicitée ci-dessus se divise en deux sous-phases : une phase de calibration dite « en décharge » et une phase de calibration dite « en charge ».

En pratique, pour établir la calibration en décharge, il est choisi $n_{Pd}$ puissances de décharge et $n_{SoEd}$ valeurs d'états de charge initial, puis il est procédé à des cycles de charges/décharges permettant de mesurer l'énergie disponible $e_{dij}$ réelle pour chaque couple de ces valeurs ($P_{di}$, $SOE_{0j}$), où les indices i et j parcourent respectivement les $n_{Pd}$ et $n_{SoEd}$ valeurs, soit pour chacune des $n_{mesd} = n_{Pd}*n_{SoEd}$ combinaisons possibles.

Notamment, ce procédé met en oeuvre les étapes suivantes :

- chargement à pleine charge de l'accumulateur, selon une procédure recommandée par le fabricant et/ou la plus adaptée à la technologie de l'accumulateur concerné ;

- décharge à puissance constante égale à la puissance nominale $P_{nomd}$ de l'accumulateur jusqu'à une énergie déchargée définie par $(1- SoE_{0j})xE_{nomd}$ , permettant de l'amener à l'état initial $SOE_{0j}$, où $E_{nomd}$ correspond à l'énergie nominale de l'accumulateur
- décharge totale à puissance constante égale à $P_{di}$ de l'accumulateur et mesure de l'énergie totale déchargée lors de cette décharge totale, qui correspond à l'énergie disponible $e_{dij}$.

Les étapes précédentes sont réitérées successivement pour chacune des $n_{SoEd}$ valeurs d'états de charge initiaux et des $n_{Pd}$ valeurs de puissance $P_{di}$ choisies.

De manière semblable, pour établir la calibration en charge, il est choisi $n_{Pc}$ puissances de charge $P_c$ et $n_{SoEc}$ valeurs d'états de charge initial $SOE_0$, puis il est procédé à des cycles de charges/décharges permettant de mesurer l'énergie recevable $a_{ij}$ réelle pour chaque couple de ces valeurs ($P_{ci}$, $SOE_{0j}$), où les indices i et j parcourent respectivement les $n_{Pc}$ et $n_{SoEc}$ valeurs, soit pour chacune des $n_{mesc}=n_{Pc}*n_{SoEc}$ combinaisons possibles.

Notamment, ce procédé met en oeuvre les étapes suivantes :

- chargement à pleine charge de l'accumulateur, selon une procédure recommandée par le fabricant et/ou la plus adaptée à la technologie de l'accumulateur concerné ;
- décharge à puissance constante égale à la puissance nominale $P_{nomd}$ de l'accumulateur jusqu'à une énergie déchargée définie par $(1- SOE_{0j})xE_{nomd}$ , permettant de l'amener à l'état initial $SOE_{0j}$, où $E_{nomd}$ correspond à l'énergie nominale de l'accumulateur ;

- charge complète de l'accumulateur à puissance constante égale à $P_{ci}$ et mesure de l'énergie totale chargée lors de cette charge complète, qui correspond à l'énergie recevable $a_{ij}$ ;
- décharge totale de l'accumulateur à puissance constante égale à la puissance nominale de décharge et mesure de l'énergie déchargée.

Les étapes précédentes sont réitérées successivement pour chacune des $n_{SoEc}$ valeurs d'états de charge initiaux et des $n_{Pc}$ valeurs de puissance $P_{ci}$ choisies.

En remarque, la dernière étape ci-dessus sert à l'établissement d'un tableau d'efficacité de charge, outre la remise de l'accumulateur à son état vide pour pouvoir réitérer les étapes listées ci-dessus. En effet, il s'avère que les charges dans des conditions différentes des conditions nominales ne permettent pas la restitution de la même quantité d'énergie en décharge, ce qui signifie que ces charges ne ramènent pas l'accumulateur à un état d'énergie égale à 1. De manière semblable, une décharge complète d'un accumulateur à puissance plus élevée que la puissance nominale ne permet pas toujours de l'amener à un état de charge nul : on le constate par le fait qu'il est parfois toujours possible d'obtenir une restitution d'énergie importante à puissance nominale après une période de repos d'un accumulateur, même si on a procédé auparavant à une décharge complète à forte puissance.

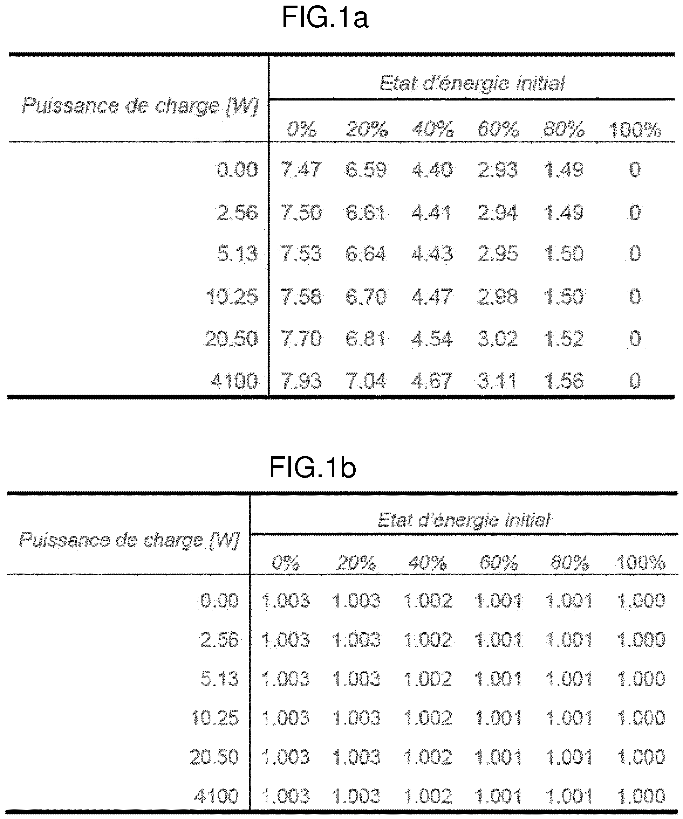

Or les procédés décrits précédemment font l'hypothèse que l'énergie chargée ou déchargée à chaque sous-étape est égale à la proportion de l'énergie nominale de charge ou décharge définie par le changement de l'état d'énergie effectué. Cette hypothèse est vraie si l'efficacité de charge ou de décharge est égale à 1 pour toutes les valeurs de puissance et état d'énergie initial. Comme cela a été mentionné ci-dessus, cette hypothèse n'est pas vérifiée en pratique. En effet, le phénomène décrit ci-dessus induit que le procédé décrit précédemment fournit des mesures réelles des énergies disponibles et recevables pas tout à fait exactes. C'est pourquoi il est défini des tableaux correctifs de l'efficacité de charge, en complément des tableaux de caractérisation comprenant les triplets mesurés. Les figures 1a et 1b montrent à titre d'exemple des tableaux établis par cette méthode de caractérisation de l'état de la technique.

Le comportement d'un accumulateur dépend aussi de la température de fonctionnement. Ainsi, d'autres solutions, comme celle décrite par le document WO2013175005 par exemple, ajoutent la température comme dimension supplémentaire lors de la calibration d'un accumulateur, ce qui nécessite alors des itérations complémentaires pour différentes valeurs de températures.

Les approches décrites ci-dessus permettent d'acquérir une connaissance utile d'un accumulateur, qui permet sa gestion ultérieure efficace. Toutefois, elles nécessitent un temps important pour effectuer la phase de calibration. Ce temps peut être estimé par la somme des temps nécessaires pour la phase de calibration en décharge $T_{caracd}$ et pour la phase de calibration en charge $T_{caracc}$, ces temps pouvant être approximés de la manière suivante :

$$Tcaracd = \sum_{k=1}^{n\theta d} \sum_{i=1}^{nPd} \sum_{j=1}^{nSoEd} \left( \frac{Enomc}{Pnomc} + 3.\ Tp + (1-SoEkj).\frac{Enomd}{Pnomd} + SoEkj.\frac{Enomd}{Pdi} \right)$$

Et

$$Tcaracc = \sum_{k=1}^{n\theta c} \sum_{i=1}^{nPc} \sum_{j=1}^{nSoEc} \left( \frac{Enomc}{Pnomc} + 4. \ Tp + (1-SOEkj). \frac{Enomc}{Pnomc} + SOEkj. \frac{Enomc}{Pci} + \frac{Enomd}{Pnomd} \right)$$

Où

$n_{\theta d}$ et $n_{\theta c}$ représentent les nombres de valeurs de température mesurées respectivement en décharge et en charge, $n_{Pd}$ et $n_{Pc}$ les nombres de puissances étudiées et $n_{SoEd}$ et $n_{SoEc}$ les nombres de valeurs d'états de charge respectivement en décharge et en charge,
$E_{nomc}$ représente l'énergie nominale de charge, c'est-à-dire l'énergie chargée lors d'une charge complète depuis l'état vide, et
$P_{nomc}$ la puissance de charge en régime nominal,
$E_{nomd}$ représente l'énergie nominale de décharge, c'est-à-dire l'énergie déchargée lors d'une décharge complète depuis l'état plein, et
$P_{dnom}$ la puissance de décharge en régime nominal, et
$T_p$ est un temps de repos qui s'applique entre les sous-étapes mentionnées précédemment.

Comme cela a été explicité précédemment, les approches de l'état de la technique sont soit très complexes à mettre en oeuvre, soit nécessitent un temps très long, et restent donc insatisfaisantes.

Ainsi, un objet général de l'invention est de proposer une autre solution pour gérer un accumulateur, et notamment savoir déterminer son énergie disponible.

A cet effet, l'invention repose sur un procédé de caractérisation d'un accumulateur électrochimique, comprenant une étape de mesures de multiplets incluant une valeur d'énergie disponible $e_d$ en décharge et/ou d'énergie recevable $a_r$ en charge pour un état d'énergie initial $SoE_0$ et pour respectivement des conditions de décharge $Y_D$, comprenant une grandeur continue qui caractérise la décharge de façon univoque, notamment donnée par la puissance de décharge $P_d$, et des conditions de charge $X_C$, comprenant une grandeur continue qui caractérise la charge de façon univoque, notamment donnée par la puissance de charge $P_c$, caractérisé en ce qu'il comprend une itération des étapes suivantes dans l'ordre suivant pour plusieurs valeurs d'énergie $E_{Di}$ prédéfinies pour une caractérisation en décharge de l'accumulateur :

-   décharge partielle dans des conditions de décharge $Y_D$ d'une énergie $E_{Di}$ à partir de l'état plein de l'accumulateur, et calcul de l'énergie disponible $e_{di}$,
-   charge ou décharge complète de l'accumulateur et mesure de l'énergie chargée ou déchargée $E_{E16}$,
-   calcul de l'état d'énergie initial $SOE_{0i}$ associé aux conditions de décharge $Y_D$ et à l'énergie disponible $e_{di}$ à partir de l'énergie chargée ou déchargée $E_{E16}$;

ET/OU
en ce qu'il comprend une itération des étapes suivantes dans l'ordre suivant pour plusieurs valeurs d'énergie $E_{Ci}$ prédéfinies pour une caractérisation en charge de l'accumulateur :

-   charge partielle dans des conditions de charge $X_C$ d'une énergie $E_{Ci}$ à partir d'un état vide de l'accumulateur, et calcul de l'énergie recevable $a_{ri}$,
-   charge ou décharge complète de l'accumulateur et mesure de l'énergie chargée ou déchargée $E_{E26}$,
-   calcul de l'état d'énergie initial $SOE_{0i}$ associé aux conditions de charge $X_C$ et à l'énergie recevable $a_{ri}$ à partir de l'énergie chargée ou déchargée $E_{E26}$.

Le procédé de caractérisation d'un accumulateur peut comprendre les deux étapes préalables suivantes pour une caractérisation en décharge de l'accumulateur :

-   décharge complète dans les conditions de décharge $Y_D$ de l'accumulateur et mesure de l'énergie déchargée pour en déduire l'énergie disponible $e_d(Y_D ; SoE_0=1)$ pour un état d'énergie initial plein ($SoE_0 = 1$);
-   charge complète dans les conditions nominales ;

ET/OU
peut comprendre les deux étapes préalables suivantes pour une caractérisation en charge de l'accumulateur :

- charge complète dans les conditions de charge $X_C$ de l'accumulateur et mesure de l'énergie chargée, pour en déduire l'énergie recevable $a_r(X_C ; SoE_0=0)$ pour un état d'énergie nul ($SoE_0= 0$);
- décharge complète dans les conditions nominales.

Le procédé de caractérisation d'un accumulateur peut comprendre, pour une caractérisation en décharge de l'accumulateur, suite à la décharge partielle, un calcul de l'énergie disponible $e_{di}$ par le calcul

$$e_{di} = e_d(Y_D ; SoE_0=1) - E_{Di}$$

ET/OU
peut comprendre, pour une caractérisation en charge de l'accumulateur, suite à la charge partielle, un calcul de l'énergie recevable $a_{ri}$ par le calcul

$$a_{ri} = a_r(X_C ; SoE_0=0) - E_{Ci}.$$

Le procédé de caractérisation d'un accumulateur électrochimique peut comprendre, pour une caractérisation en décharge de l'accumulateur, le calcul de l'état d'énergie initial $SoE_{0i}$ associé aux conditions de décharge $Y_D$ et à l'énergie disponible $e_{di}$ de la manière suivante : $SoE_{0i} = E_{E16}/ E_{nomd}$ ET/OU
peut comprendre, pour une caractérisation en charge de l'accumulateur, le calcul de l'état d'énergie initial $SoE_{0i}$ associé aux conditions de charge $X_C$ et à l'énergie recevable $a_{ri}$ de la manière suivante : $SoE_{0i} = E_{E26}/ E_{nomd}$ où $E_{nomd}$ représente l'énergie nominale de l'accumulateur.

Le procédé de caractérisation d'un accumulateur électrochimique peut comprendre, pour une caractérisation en décharge de l'accumulateur, le calcul d'une fonction $\Phi$ permettant de relier l'énergie disponible $e_d(Y_D, SoE_0)$ de l'accumulateur aux conditions de décharges $Y_D$ et à un état d'énergie initial $SoE_0$ de l'accumulateur, cette fonction étant définie par $e_d(Y_D, SoE_0) = \Phi(Y_D, SoE_0)$ et étant déterminée par une extrapolation à partir des multiplets mesurés, ET/OU
peut comprendre, pour une caractérisation en charge de l'accumulateur, le calcul d'une fonction $\psi$ permettant de relier l'énergie recevable $a_r(X_C, SoE_0)$ de l'accumulateur aux conditions de charges $X_C$ et un état d'énergie initial $SoE_0$ de l'accumulateur, cette fonction étant définie par $a_r(X_C, SoE_0) = \psi(X_C ; SoE_0)$ et étant déterminée par une extrapolation à partir des multiplets mesurés.

Pour une caractérisation en décharge de l'accumulateur, le procédé peut comprendre une étape de charge complète de l'accumulateur dans des conditions de charge $X_{E16}$ et une mesure de l'énergie chargée $E_{E16}$, et le calcul de l'état d'énergie initial $SoE_{0i}$ associé aux conditions de décharge $Y_D$ et à l'énergie disponible $e_{di}$ de la manière suivante :

$$SoE_{0i}=\psi^{-1}(X_{E16} ; E_{E16}) ;$$

ou
pour une caractérisation en décharge de l'accumulateur, le procédé peut comprendre une étape de décharge complète de l'accumulateur dans des conditions de décharge $Y_{E16}$ et une mesure de l'énergie déchargée $E_{E16}$, et le calcul de l'état d'énergie initial $SoE_{0i}$ associé dans des conditions de décharge $Y_D$ et à l'énergie disponible $e_{di}$ de la manière suivante : $SoE_{0i} =\Phi^{-1}(Y_{E16} ; E_{E16})$;
OU
pour une caractérisation en charge de l'accumulateur, le procédé peut comprendre une étape de charge complète de l'accumulateur dans des conditions de charge $X_{E26}$ et une mesure de l'énergie chargée $E_{E26}$, et le calcul de l'état d'énergie initial $SoE_{0i}$ associé aux conditions de charge $X_C$ et à l'énergie disponible $e_{di}$ de la manière suivante :

$$SoE_{0i} = \psi^{-1}(X_{E26} ; E_{E26}) ;$$

ou
pour une caractérisation en charge de l'accumulateur, le procédé peut comprendre une étape de décharge complète de l'accumulateur dans des conditions de décharge $Y_{E26}$ et une mesure de l'énergie déchargée $E_{E26}$, et le calcul de l'état d'énergie initial $SoE_{0i}$ associé aux conditions de charge $X_C$ et à l'énergie disponible $e_{di}$ de la manière suivante :

$$SoE_{0i} = \Phi^{-1}(Y_{E26} ; E_{E26}).$$

L'étape de charge ou de décharge complète de l'accumulateur peut être réalisée dans des conditions nominales ou non nominales.

Le procédé de caractérisation d'un accumulateur électrochimique peut comprendre :

- lors d'une caractérisation en décharge de l'accumulateur, une étape de décharge complète pour atteindre un état d'énergie final $SoE_{fd}$ en décharge au-dessous duquel il n'est plus possible d'obtenir de l'énergie dans les conditions de décharge $Y_D$ données, et peut comprendre une étape de calcul d'une fonction f reliant l'état d'énergie final $SoE_{fd}$ en décharge aux conditions de décharge définie par $SoE_{fd} = f(Y_D)$ ;
  OU
- lors d'une caractérisation en charge de l'accumulateur, une étape de charge complète pour atteindre un état d'énergie final $SoE_{fc}$ en charge au-dessus duquel il n'est plus possible d'obtenir de fournir de l'énergie dans les conditions de charge $Y_C$ données, et peut comprendre une étape de calcul d'une fonction f2 reliant l'état d'énergie final $SoE_{fc}$ en charge aux conditions de charge définie par $SoE_{fc} = f2(Y_C)$.

Lors d'une caractérisation en décharge de l'accumulateur, le procédé peut comprendre les étapes suivantes :

- choix des conditions de décharge $Y_{Dj}$ ;

  - décharge complète de l'accumulateur à partir de son état plein, dans les conditions de décharge $Y_{Dj}$, et mesure de l'énergie déchargée, qui correspond à l'énergie disponible $e_d(Y_{Dj} ; SoE_{01}=1)$ pour un état initial plein de l'accumulateur ;
  - charge nominale complète de l'accumulateur ;
  - choix de l'énergie $E_{di}$ à décharger ;
  - répétition d'un procédé tel que décrit précédemment,
  - décompte du nombre d'énergie à décharger déjà caractérisée et comparaison avec un nombre d'états de charge initiaux $n_{SoEd}$ choisi, et si ce nombre n'est pas atteint, nouvelle itération des étapes précédentes,

- décompte du nombre de conditions de décharge déjà caractérisées et comparaison avec un nombre de conditions de décharge $n_{Pd}$ choisi et si ce nombre n'est pas atteint, retour à l'étape et répétition des étapes précédentes ;

  OU

- lors d'une caractérisation en décharge de l'accumulateur, le procédé peut comprendre les étapes suivantes :

  - choix des conditions de charge $X_{Cj}$ ;
  - charge complète de l'accumulateur à partir de son état vide dans les conditions de charge $X_{Cj}$ et mesure de l'énergie chargée, qui correspond à l'énergie recevable $a_r(X_{Cj} ; SoE_{01}=0)$ pour un état initial vide de l'accumulateur ;
  - décharge nominale complète ;
  - choix de l'énergie $E_{Ci}$ à charger ;
  - répétition d'un procédé tel que décrit précédemment,
  - décompte du nombre d'énergie à charger déjà caractérisée et comparaison avec un nombre d'états de charge initiaux $n_{SoEc}$ choisi, et si ce nombre n'est pas atteint, nouvelle itération des étapes,

- décompte du nombre de conditions de charge déjà caractérisées et comparaison avec un nombre de conditions de charge $n_{Pc}$ choisi et si ce nombre n'est pas atteint, retour à l'étape et répétition des étapes précédentes.

Lors d'une caractérisation en décharge de l'accumulateur, le procédé peut comprendre une étape préalable de détermination d'un nombre $n_{Pd}$ de valeurs de puissance de décharge $P_{dj}$ supérieur à un et de détermination d'un nombre $n_{SoEd}$ de valeurs d'états d'énergie initial $SoE_{0j}$ supérieur à un, et peut comprendre, pour chaque valeurs de puissance de décharge $P_{dj}$, une sélection de $n_{SoEd}$ valeurs d'énergie $E_{Di}$ à décharger dans l'étape de décharge partielle (E15), réparties de manière homogène entre 0 et l'énergie disponible maximale à la puissance de décharge $P_{dj}$ pour l'état plein de l'accumulateur, ou réparties de manière non homogène ;
ET/OU
lors d'une caractérisation en charge de l'accumulateur, le procédé peut comprendre une étape préalable de détermination d'un nombre $n_{Pc}$ de valeurs de puissance de charge $P_{cj}$ supérieur à un et de détermination d'un nombre $n_{SoEc}$ de valeurs d'états d'énergie initial $SoE_{0j}$ supérieur à un, et peut comprendre, pour chaque valeurs de puissance de charge $P_{cj}$, une sélection de $n_{SoEc}$ valeurs d'énergie $E_{Ci}$ à charger dans l'étape de charge partielle, réparties de manière homogène entre 0 et l'énergie recevable maximale à la puissance de charge $P_{cj}$ pour l'état vide de l'accumulateur, ou réparties de manière non homogène.

L'invention porte aussi sur un procédé d'estimation de l'énergie disponible et/ou recevable d'un accumulateur électrochimique, caractérisé en ce qu'il comprend une première phase de mise en oeuvre du procédé de caractérisation tel que décrit précédemment, puis une seconde phase d'estimation de l'état d'énergie et/ou de l'énergie disponible et/ou recevable de l'accumulateur à partir des données mémorisées lors de la première phase de caractérisation.

Le procédé peut comprendre l'estimation de l'état d'énergie et de l'énergie disponible et/ou recevable par les étapes :

- lors d'une décharge de l'accumulateur, considération d'une période k de durée $t_k$ pendant laquelle l'accumulateur dans un état d'énergie $SOE_k$ initial subit une décharge à puissance constante $P_D$ :

    - calcul de l'énergie disponible $E_{dk}$ dans l'accumulateur par la formule $E_{dk} = \Phi (P_D ; SOE_k)$ et mesure de l'énergie restituée par l'accumulateur durant la période k par le calcul $P_D * t_k$ ;
    - calcul de l'énergie disponible $E_{dk+1}$ dans l'accumulateur en fin de période par la formule $E_{dk+1} = E_{dk} - P_D * t_k$ ;
    - calcul de l'état d'énergie $SOE_{k+1}$ de l'accumulateur en fin de période par la formule $SOE_{k+1} = \Phi^{-1} (P_D ; E_{dk+1})$ ;

    ET/OU
- lors d'une charge de l'accumulateur, considération d'une période k de durée $t_k$ pendant laquelle l'accumulateur dans un état d'énergie $SOE_k$ initial subit une charge à puissance constante $P_c$ :

    - calcul de l'énergie recevable $E_{rk}$ dans l'accumulateur par la formule $E_{rk} = \psi(P_c ; SOE_k)$ et mesure de l'énergie reçue par l'accumulateur durant la période k par le calcul $P_c * t_k$ ;
    - calcul de l'énergie recevable $E_{rk+1}$ dans l'accumulateur en fin de période par la formule $E_{rk+1} = E_{rk} + P_c * t_k$ ;
    - calcul de l'état d'énergie $SOE_{k+1}$ de l'accumulateur en fin de période par la formule $SOE_{k+1} = \psi^{-1} (P_c ; E_{rk+1})$.

L'invention porte aussi sur un dispositif comprenant au moins un accumulateur électrochimique, caractérisé en ce qu'il comprend un moyen d'estimation de l'énergie disponible mettant en oeuvre un procédé tel que décrit ci-dessus.

Ces objets, caractéristiques et avantages de la présente invention seront exposés en détail dans la description suivante d'un mode d'exécution particulier fait à titre non-limitatif en relation avec les figures jointes parmi lesquelles :

Les figures 1a et 1b représentent respectivement des exemples de tableaux de données d'énergie recevable et d'efficacité de charge obtenus par une méthode de calibration selon l'état de la technique.

La figure 2 représente l'ordinogramme des étapes du coeur du procédé de caractérisation en décharge selon un mode d'exécution de l'invention.

La figure 3 représente respectivement l'évolution de l'état d'énergie et des puissance et énergie mises en oeuvre lors des itérations du procédé de caractérisation en décharge selon le mode d'exécution de l'invention.

La figure 4 représente l'ordinogramme des étapes du coeur du procédé de caractérisation en charge selon un mode d'exécution de l'invention.

La figure 5 représente respectivement l'évolution de l'état d'énergie et des puissance et énergie mises en oeuvre lors des itérations du procédé de caractérisation en charge selon le mode d'exécution de l'invention.

La figure 6 représente respectivement l'évolution de la tension, du courant et de la puissance aux bornes de l'accumulateur lors des itérations du procédé de caractérisation en charge selon le mode d'exécution de l'invention.

La figure 7 représente un exemple de surface formée par l'ensemble des triplets obtenus par le procédé de caractérisation en charge selon le mode d'exécution de l'invention.

La figure 8 représente l'ordinogramme des étapes du procédé de caractérisation en charge selon un mode d'exécution de l'invention.

La figure 9 représente l'ordinogramme des étapes du procédé de caractérisation en décharge selon un mode d'exécution de l'invention.

La figure 10 représente respectivement l'évolution de l'état d'énergie et des puissance et énergie mises en oeuvre lors de certaines itérations du procédé de caractérisation en décharge selon le mode d'exécution de l'invention.

La figure 11 représente l'ordinogramme des étapes d'un procédé de suivi de l'état d'un accumulateur, à partir des données de caractérisation, selon un mode d'exécution de l'invention.

Avant de détailler les étapes importantes d'un mode d'exécution de l'invention, il convient au préalable d'apporter quelques définitions.

Nous utiliserons le paramètre Y pour désigner les conditions de décharge d'un accumulateur, c'est-à-dire les conditions opératoires auxquelles il est soumis lors de sa décharge. Ce paramètre peut ainsi comprendre la puissance de décharge $P_d$ (voire en variante le courant de décharge $I_d$ ou un autre paramètre continument variable qui caractérise les conditions de décharge de façon univoque). Il peut aussi comprendre la température extérieure ou intérieure $\theta$ de l'accumulateur. Ainsi, Y désignera soit le paramètre $P_d$, soit le vecteur $(P_d, \theta)$ dans les modes de réalisation décrits, à titre non limitatif.

De manière similaire, nous utiliserons le paramètre X pour désigner les conditions de charge d'un accumulateur, c'est-à-dire les conditions opératoires auxquelles il est soumis lors de sa charge. Ce paramètre peut ainsi comprendre la puissance de charge $P_c$ (voire en variante le courant de charge $I_c$ ou un autre paramètre continument variable qui caractérise les conditions de charge de façon univoque). Il peut aussi comprendre la température extérieure ou intérieure $\theta$ de l'accumulateur. Ainsi, X désignera soit le paramètre $P_c$, soit le vecteur $(P_c, \theta)$ dans les modes de réalisation décrits, à titre non limitatif.

Nous appelons critères de fin de décharge un ensemble de conditions opérationnelles définies par l'opérateur de l'accumulateur qui limitent les conditions d'opération auxquelles ce dernier est soumis en décharge de façon à respecter le domaine de fonctionnement sécuritaire de l'accumulateur. Elles peuvent être obtenues à partir des recommandations du constructeur de l'accumulateur et varient selon la technologie. En général, les critères de fin de décharge reposent sur la tension et le courant mesurés aux bornes de l'accumulateur sous forme d'un seuil de tension $U_{fd}$, un seuil de courant $I_{fd}$, ou sur une impédance, une pente de tension, et/ou une pente d'impédance, à titre non limitatif. Ainsi, nous appelons toute décharge qui se termine en atteignant les critères de fin de décharge une décharge complète.

De manière analogue, nous appelons critères de fin de charge un ensemble de conditions opérationnelles qui limitent la plage opérationnelle de l'accumulateur en charge selon la technologie. Toute charge qui se termine en atteignant les critères de fin de charge est ainsi désignée une charge complète.

Nous appelons conditions de charge nominale $X_{nom}$ et de décharge nominale $Y_{nom}$ un ensemble de conditions respectivement de charge et de décharge de référence. Selon un mode de réalisation, les conditions de décharge nominale désignent une puissance nominale qui peut être définie selon les deux approches suivantes :

- la puissance nominale $P_{nomd}$ se trouve dans une plage de puissance d'utilisation recommandée par le fabricant de l'accumulateur, soit directement fournie par ce fabricant soit déduite par exemple d'une plage de courant fournie par ce fabriquant, par multiplication par une tension nominale fournie ; ou,
- la puissance nominale $P_{nomd}$ doit permettre d'effectuer des décharges les plus reproductibles possibles selon la technologie testée. Par exemple, cet objectif peut être atteint en déduisant la puissance nominale $P_{nomd}$ de la capacité nominale $C_{nom}$ et de la tension nominale $U_{nom}$, par la formule $P_{nomd} = C_{nom} \cdot U_{nom} / T_{nomd}$, $T_{nomd}$ étant la durée nominale de la décharge.

Une charge nominale complète est effectuée lorsque l'accumulateur est soumis aux conditions de charge nominale $X_{nom}$ jusqu'à ce que les critères de fin de charge soient atteints. Nous appelons état plein ou pleinement chargé l'état de l'accumulateur ainsi obtenu.

De manière similaire, nous appelons état vide ou pleinement déchargé l'état de l'accumulateur lorsqu'une décharge sous les conditions de décharge nominale $Y_{nom}$ se termine en atteignant les critères de fin de décharge.

Les conditions de décharge nominale $Y_{nom}$ permettent de déterminer une énergie nominale de décharge $E_{nomd}$ définie par l'énergie délivrée par l'accumulateur lorsqu'il est déchargé dans les conditions $Y_{nom}$ depuis son état plein jusqu'à un état pleinement déchargé.

Avantageusement, la mesure de l'énergie nominale $E_{nomd}$ est obtenue par un cyclage de l'accumulateur aux conditions de charge et de décharge nominale en moyennant l'énergie déchargée lors de la décharge sur un nombre $n_{cyc}$ de cycles, compris entre 2 et 6.

L'énergie disponible $e_d(Y, SOE_0)$ d'un accumulateur représente l'énergie qui peut être restituée aux bornes de l'accumulateur lors d'une décharge complète dans les conditions Y et à partir d'un état d'énergie initial $SOE_0$. L'énergie

disponible nominale en décharge $E_{nomd}$ est obtenue pour une décharge à partir d'un état plein ($SOE_0=1$) dans les conditions $Y_{nom}$.

L'énergie recevable $a_r(X, SOE_0)$ d'un accumulateur représente l'énergie qui peut être acceptée par l'accumulateur lors d'une charge complète dans les conditions X et à partir d'un état d'énergie initial $SOE_0$. L'énergie recevable nominale en charge $E_{nomc}$ est obtenue lors d'une charge à partir de l'état vide ($SOE_0=0$) dans les conditions $X_{nom}$.

Enfin, un état d'énergie, dénommé communément par l'acronyme SoE de sa dénomination anglaise « State of Energy », est défini comme le rapport entre l'énergie disponible $e_d(Y_{nom}, SoE)$ dans l'hypothèse d'une décharge d'énergie dans les conditions nominales de décharge $Y_{nom}$ de l'accumulateur à partir de son état actuel SoE et l'énergie nominale de décharge $E_{nomd}$, donc défini par la formule $SoE = e_d(Y_{nom}, SoE) / E_{nomd}$. Une valeur égale à 1 correspondant à un état d'énergie de l'accumulateur pleinement chargé et la valeur égale à 0 comme un état vide.

L'invention repose sur un procédé de caractérisation d'un accumulateur électrochimique, qui permet de mesurer plusieurs multiplets de données, incluant notamment des triplets de données selon un mode de réalisation avantageux, chaque triplet associant un état d'énergie initial $SoE_{0i}$, une puissance de décharge $P_{di}$ et une énergie disponible $e_{di}$ dans une partie de caractérisation en décharge, et un état d'énergie initial $SoE_{0j}$, une puissance de charge $P_{cj}$ et une énergie recevable $a_{rj}$ dans une partie de caractérisation en charge, de manière semblable à l'état de la technique. Toutefois, le procédé de caractérisation choisi pour obtenir les valeurs des multiplets est beaucoup plus rapide que dans l'état de la technique, comme cela va être décrit par la suite. Le procédé est avantageusement mis en oeuvre pour une caractérisation en décharge et en charge d'un accumulateur, mais resterait naturellement utile pour une seule de ces deux caractérisations. D'autre part, nous entendrons par mesure d'énergie, une valeur obtenue à partir d'une mesure d'une quantité de charges restituée par un accumulateur ou fournie à un accumulateur, ou à partir de toute autre mesure d'une ou plusieurs grandeurs électriques aux bornes de l'accumulateur, comme la tension, le courant, et/ou la puissance.

En remarque, l'invention va souvent être décrite dans le cadre des triplets de données susmentionnés, à titre d'exemple, mais pourrait naturellement être étendue à d'autres dimensions, intégrant la température dans les conditions de décharge et/ou de charge par exemple. Les paramètres de décharge Y et de charge X définis plus hauts et qui seront utilisés ci-après peuvent donc correspondre par exemple à une puissance de décharge et de charge, ou en variante représenter un vecteur pour intégrer d'autres paramètres.

Ainsi, l'invention permet aussi d'estimer l'état d'énergie d'un accumulateur, et son énergie disponible et/ou recevable, grâce à la mise en oeuvre d'une part du procédé de caractérisation de l'accumulateur dans une première phase P1, qui permet d'acquérir des valeurs réelles de référence du comportement de l'accumulateur, que nous pouvons aussi appeler données de caractérisation, et d'autre part d'une estimation de son état dans une seconde phase P2 pendant son utilisation dans un système durant laquelle il alterne des périodes de restitution d'énergie pour alimenter électriquement ledit système et des périodes de charge pour stocker de l'énergie, à partir des données de caractérisation.

L'invention s'intéresse particulièrement à la première phase P1 correspondant au procédé de caractérisation, dont elle permet une optimisation grâce à un gain de temps significatif pour sa mise en oeuvre. Ce procédé de caractérisation est de préférence mis en oeuvre dans des conditions particulières bien maîtrisées, sur un accumulateur dans une phase en amont de son utilisation dans un système.

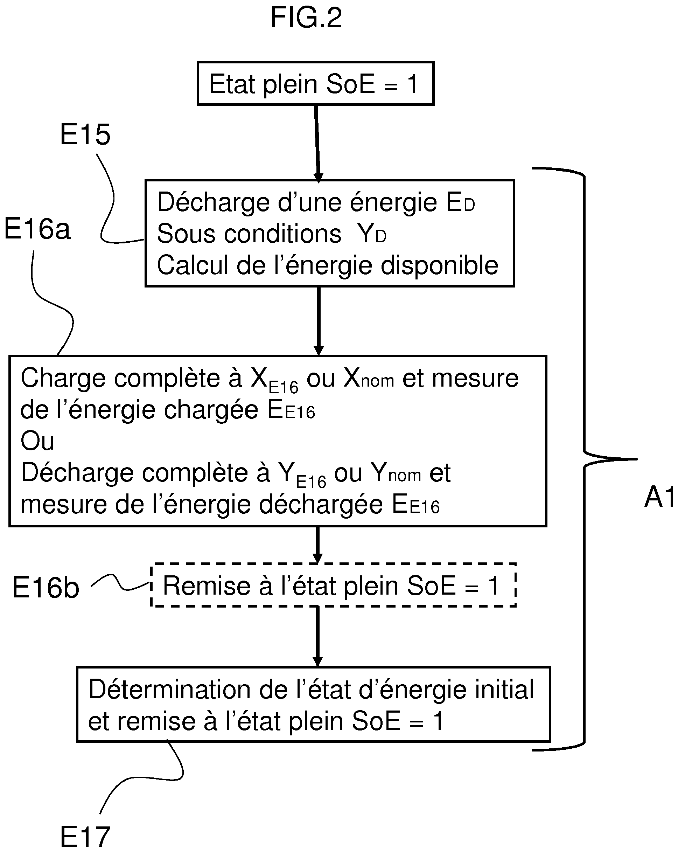

La figure 2 illustre un algorithme A1 mis en oeuvre dans le coeur d'un procédé de caractérisation en décharge d'un accumulateur, selon un mode de réalisation de l'invention. Cet algorithme A1 est mis en oeuvre à partir d'un état plein de l'accumulateur, caractérisé par un état d'énergie SoE par définition égal à 1. Il comprend les étapes suivantes :

- une décharge partielle E15 de l'accumulateur d'une quantité d'énergie $E_D$ prédéfinie, dans les conditions de décharge $Y_D$ ;
- une charge ou décharge complète E16a dans les conditions nominales $X_{nom}/Y_{nom}$ durant laquelle l'énergie chargée ou déchargée $E_{E16}$ est mesurée ;
- Une remise de l'accumulateur à sa position de départ de l'algorithme A1 en état plein E16b par une charge nominale complète ;
- une détermination de l'état d'énergie initial E17, dans lequel se trouvait l'accumulateur après l'étape de décharge partielle E15 et avant d'engager l'étape de charge ou décharge complète E16a.

En première remarque, il est important de noter que cet algorithme A1, qui forme le coeur du procédé de caractérisation en décharge et qui sera itéré plusieurs fois pour obtenir des multiplets de valeur, avec notamment des puissances de décharge différentes et des états d'énergie initiaux différents, se différencie de celui défini par l'état de la technique, décrit dans le document WO2011000872 rappelé précédemment, par le fait que l'accumulateur n'est pas positionné d'abord dans un état d'énergie initial connu avant la mesure de son énergie disponible, mais au contraire par le fait qu'on procède à une décharge partielle E15, puis une charge ou décharge E16a à partir d'un état d'énergie inconnu, qui est calculé a posteriori en dernière étape E17 de l'algorithme A1. Les avantages de cette approche seront détaillés ultérieurement.

En deuxième remarque, la charge nominale de l'étape E16b n'est pas effectuée si l'étape E16a comprend une charge nominale. Si l'étape E16a comprend une charge nominale, l'accumulateur est déjà dans l'état plein de départ requis à la fin de l'étape E16a, ce qui rend l'étape E16b inutile.

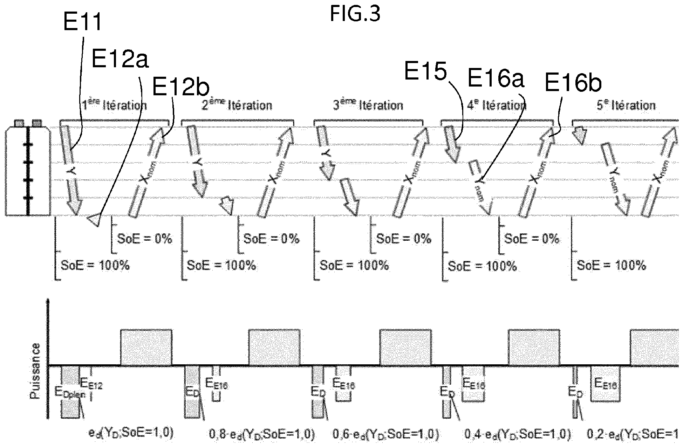

La mise en oeuvre de cet algorithme A1 va maintenant être détaillée, en référence avec la figure 3. Cet algorithme est itéré pour obtenir des mesures d'énergie disponible pour plusieurs états d'énergie initiaux, sans modifier les conditions de décharge $Y_D$ considérées. La variation de l'état d'énergie initial est réalisée en modifiant l'énergie déchargée $E_D$ à l'étape de décharge partielle E15, sans définition préalable de plusieurs états d'énergie initiaux $SOE_{0i}$ spécifiques, qui restent inconnus au début de l'algorithme A1.

Au moins une fois pendant la caractérisation en décharge, une itération particulière de l'algorithme A1 est réalisée en appliquant une décharge complète E11 de l'accumulateur depuis son état plein dans les conditions de décharge $Y_D$. A la fin de cette étape, l'accumulateur atteint ainsi les critères de fin de décharge, et l'énergie déchargée et mesurée $E_{Dplein}$ correspond à l'énergie disponible $e_d$ pour un état d'énergie initial plein ($SOE_0 = 1$). Cette mise en oeuvre particulière permet ainsi de mesurer $e_d(Y_D ; SOE_0=1)$ (= $E_{Dplein}$).

Cette première mise en oeuvre de l'algorithme A1 est illustrée par la première itération sur les graphes de la figure 3. Le graphe supérieur montre l'évolution de l'état d'énergie de l'accumulateur. Au début de cette évolution, l'accumulateur se trouve dans son état plein. Ensuite, la décharge complète E11 est mise en oeuvre, comme mentionné ci-dessus, Par la suite, une décharge nominale complète est mise en oeuvre dans l'étape E12a et l'énergie déchargée $E_{E12}$ mesurée, avant une nouvelle sous-étape E12b de charge dans les conditions nominales, pour le porter à son état initial plein. La décharge nominale complète de l'étape E12a sert à la détermination de l'état final de décharge $SoE_{fd}$ de l'accumulateur dans l'étape E13 qui sera exposée plus loin.

En remarque, cette première itération particulière est effectuée avant les autres itérations de caractérisation, si ces dernières comprennent l'étape de calcul en ligne E17 ou si le calcul de l'énergie déchargée lors de l'étape E15 se base sur la connaissance de l'énergie de décharge $e_d(Y_D ; SOE_0=1)$, comme décrit par la suite.

Ensuite, l'algorithme A1 est répété pour différentes valeurs d'énergie $E_{Di}$ de décharge dans l'étape de décharge partielle E15, l'indice i étant utilisé pour caractériser l'itération i de répétition de l'algorithme A1. Avantageusement, ces valeurs d'énergie sont réparties de manière homogène entre 0 et l'énergie $E_{Dplein}=e_d(Y_D ; SOE_0=1)$ obtenue lors de la première étape. En choisissant à titre d'exemple quatre valeurs d'état d'énergie initial intermédiaire, l'énergie $E_{Di}$ de décharge est alors prédéfinie par les valeurs $0,8*E_{Dplein}$, $0,6*E_{Dplein}$, $0,4*E_{Dplein}$ et $0,2*E_{Dplein}$. En variante, toute autre répartition des énergies $E_{Di}$ pourrait être envisagée. Ces différentes valeurs sont utilisées dans les étapes 2 à 5 suivantes représentées sur la figure 3. Dans chacune de ces itérations i, on met alors en oeuvre l'algorithme A1, qui est donc répété quatre fois dans cet exemple de réalisation.

Durant l'étape E15, une décharge partielle de l'accumulateur sous conditions $Y_D$ est réalisée, et l'énergie de décharge est mesurée : dès que cette énergie déchargée atteint le seuil prédéfini $E_{Di}$, la décharge est stoppée. En remarque, il est possible de calculer l'énergie disponible $e_{di}$ dans l'accumulateur en fin de l'étape de décharge partielle E15 de cet algorithme A1 de la manière suivante : $e_{di} = e_d(Y_D ; SOE_{0i}=1) - E_{Di}$.

Ensuite, l'énergie déchargée $E_{E16}$ est alors mesurée pendant l'étape de décharge complète E16a de l'accumulateur.

Avant la fin de chaque itération, le procédé de caractérisation en décharge met en oeuvre une sous-étape E16b intermédiaire de charge complète de l'accumulateur dans les conditions nominales $X_{nom}$, pour le remettre dans son état plein, requis au début de l'algorithme A1. Cette étape est omise lors d'une réalisation de l'algorithme exposée plus loin dans laquelle l'étape E16a est réalisée par une charge nominale.

Enfin, il est possible de déterminer à l'étape E17 l'état de charge initial $SOE_{0i}$ de l'itération i par le calcul suivant :

$$SOE_{0i} = e_d(Y_{nom} ; SOE_{0i}) / E_{nomd} = E_{E16} / E_{nomd}$$

Ce calcul est remplacé par un calcul différent basé sur une caractérisation préalable en charge lors de la réalisation dans laquelle l'étape E16a est réalisée par une charge nominale.

En remarque, l'ordre des étapes E16b et E17 peut être inversé ou ces étapes peuvent être exécutées en parallèle. En outre, l'étape E17 peut être omise en faveur d'un calcul de l'état d'énergie initial hors ligne après la mise en oeuvre de toutes les itérations de l'algorithme A1.

A la fin de chaque itération, nous obtenons bien le multiplet de données recherchées, $Y_D$, $SOE_{0i}$, $e_{di}$.

De manière identique au calcul de l'étape E17, il est possible de déterminer à l'étape E13 l'état de charge final $SoE_{fd}$ de la décharge complète pendant l'étape E11 par le calcul suivant :

$$SoE_{fd} = e_d(Y_{nom} ; SoE_{fd}) / E_{nomd} = E_{E12} / E_{nomd}$$

Ce procédé présente ainsi l'avantage de permettre dans le même temps le calcul de l'état d'énergie final $SoE_{fd}$

en décharge, qui se définit comme l'état d'énergie de l'accumulateur au-dessous duquel il n'est plus possible d'obtenir de l'énergie dans des conditions de décharge $Y_D$ données. En effet, cette valeur $SoE_{fd}$ atteinte lors d'une décharge complète en fin d'étape E11, est déduite de la mesure de l'énergie chargée lors de l'étape E12a de décharge complète dans les conditions nominales. Lors d'une réalisation dans laquelle l'étape E12a est réalisée par une charge nominale, elle est calculée à base d'une caractérisation préalable en charge, comme expliqué plus loin.

La détermination de l'état final de la décharge pour toutes les conditions de décharge $Y_{Dj}$ sous investigation permet d'acquérir plusieurs couples ($SOE_{fdj}$ ; $Y_{Dj}$) à partir desquels une fonction f peut être définie par une interpolation : $SOE_{fd} = f(Y_D)$.

L'inversion de cette fonction f permet aussi de déterminer des conditions de décharge limitantes $Y_{Dlim}$ à un état d'énergie SOE donné, au-delà desquelles il n'est plus possible d'obtenir de l'énergie de l'accumulateur à cet état donné : $Y_{Dlim} = f^{-1}$ (SoE). Dans un mode de réalisation où les conditions de décharge $Y_D$ sont données par une puissance de décharge $P_d$, et en conséquence $SOE_{fd} = f(P_D)$, la fonction inverse $f^{-1}$ donne une puissance maximale de décharge.

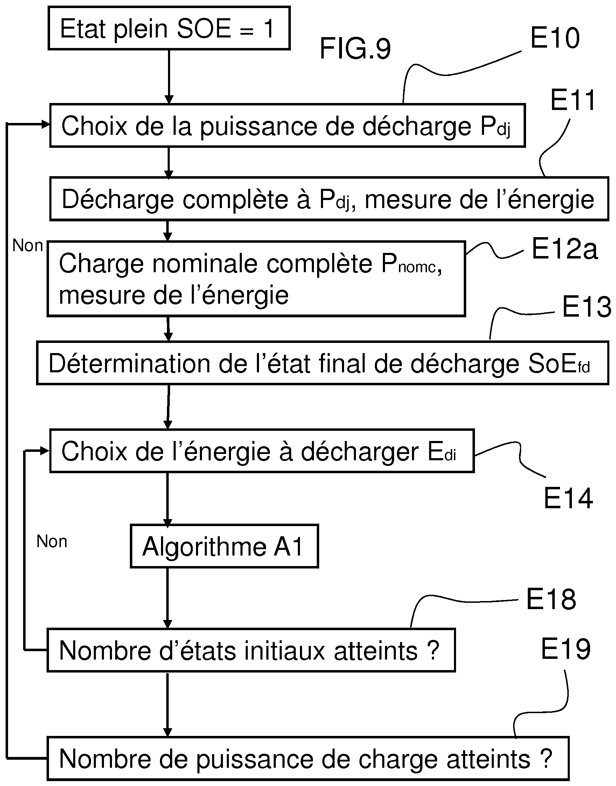

Ensuite, le procédé décrit précédemment est de nouveau répété en modifiant les conditions de décharge $Y_D$, pour finaliser l'acquisition des multiplets mentionnés dans toutes les dimensions étudiées, notamment en faisant varier les valeurs de puissance de décharge $P_d$, et éventuellement la température. Un ordinogramme complet est représenté sur la figure 9 et décrit ultérieurement, en variante de ce mode de réalisation.

Lorsque toutes les itérations sont terminées, on obtient alors des multiplets $Y_{Dj}$, $SoE_{0i}$, $e_{dji}$.

Ce procédé de caractérisation en décharge est donc réalisé sur plusieurs puissances de décharge $Pd_j$, dans la plage de puissance de fonctionnement de l'accumulateur, incluant avantageusement la puissance nominale $P_{nomd}$. Le nombre $n_{Pd}$ de ces puissances de décharge doit représenter un bon compromis entre l'exigence d'obtenir suffisamment de valeurs mesurées sur des phases de décharge de l'accumulateur selon ces diverses puissances de décharge $Pd_j$ où j varie de 1 à $n_{Pd}$, le temps de caractérisation $T_{caracd}$ et l'exigence de ne pas user l'accumulateur pour ne pas perturber des mesures ultérieures. Avantageusement, ce nombre $n_{Pd}$ de puissances de décharge choisies sera compris entre 5 et 15, ces valeurs étant incluses. Ces différentes puissances $P_{dj}$ peuvent être choisies selon une répartition uniforme sur toute la plage d'utilisation de l'accumulateur ou de manière non uniforme, pour affiner le comportement vers les plus fortes et/ou les plus faibles puissances.

De plus, le procédé de caractérisation en décharge utilise plusieurs valeurs d'état de charge initial $SoE_{0i}$, entre 0 et 1, représentant plusieurs états de charge en énergie de l'accumulateur. Le nombre $n_{SoEd}$ de ces valeurs choisies représente aussi un bon compromis pour obtenir un nombre de valeurs suffisant pour bien calibrer l'accumulateur sans toutefois entraîner son vieillissement prématuré. Un nombre compris entre 4 et 12 inclus est avantageux.

Le procédé de caractérisation en décharge exige donc la mise en oeuvre d'au moins une double itération, pour chacune des valeurs de puissance de décharge déterminées $P_{dj}$ et pour chacune des valeurs d'états de charge initial $SoE_{0i}$ déterminés, selon finalement un nombre $n_{Pd}*n_{SoEd}$ de combinaisons possibles.

Lorsque les multiplets mentionnés sont obtenus, directement et/ou indirectement à partir de mesures réelles, le procédé met en oeuvre une étape supplémentaire de détermination d'une fonction $\Phi$ permettant de déterminer l'énergie disponible $e_d$ dans l'accumulateur pour tout état d'énergie SOE et toutes conditions de décharge $Y_D$. Cette fonction se définit donc par : $e_d = \Phi(Y_D$ ; SOE).

Cette fonction $\Phi$ peut être obtenue par toute méthode à partir des valeurs mesurées, comme toute modélisation ou par extrapolation ou interpolation ou par tout traitement mathématique. Elle peut être déterminée a posteriori, par un calcul après la fin de la caractérisation à partir des valeurs mesurées et mémorisées dans une mémoire électronique. En variante, elle peut être calculée pendant le procédé de caractérisation. Dans ce dernier cas, elle peut également être calculée pour une plage limitée de la plage opérationnelle de l'accumulateur à partir d'un nombre limité de multiplets. Elle peut également être calculée pour tout état d'énergie initial SoE dans une seule condition de décharge $Y_{E16}$ si suffisamment de multiplets pour cette condition de décharge ont étés obtenus. Cela permet notamment de substituer la décharge nominale dans les étapes E12a et E16a par la condition $Y_{E16}$ pour laquelle la fonction $\Phi$ est déjà connue comme dans la première variante du procédé décrite par la suite.

Le procédé décrit précédemment peut présenter des variantes de réalisation.

Par exemple, pour certaines itérations de l'algorithme A1 les étapes de charge ou décharge complète E12a et E16a pourraient consister en une décharge complète dans des conditions de décharge non nominales $Y_{E16}$, si une fonction $\Phi$ telle que définie ci-dessus est connue sur une plage limitée d'opération qui comprend les conditions $Y_{E16}$ à base de multiplets obtenus par des itérations précédentes de l'algorithme A1. Cette étape permettrait alors toujours d'en déduire à l'étape suivante E17 l'état d'énergie initial $SoE_{0i}$ par la fonction inverse $\Phi^{-1}$ de la manière suivante : $SoE_{0i} = \Phi^{-1}(Y_{E16}$ ; $E_{E16})$.

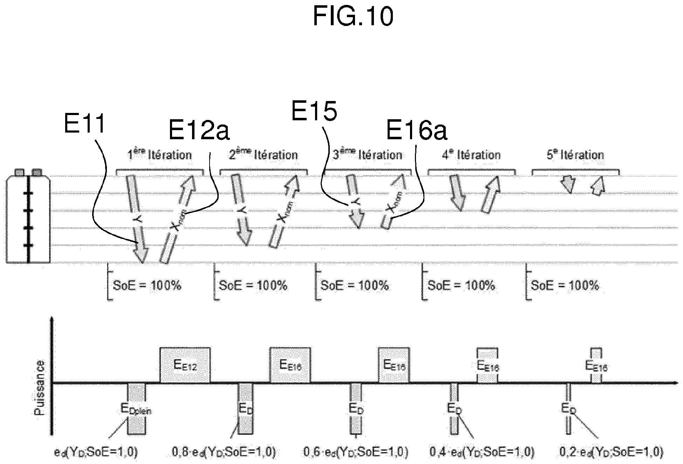

Selon une autre variante de réalisation, qui sera présentée plus loin en référence avec les figures 9 et 10, les étapes E12a et E16a peuvent être réalisée par une charge complète, dans des conditions nominales $X_{nom}$ ou non-nominales $X_{E16}$, en considérant qu'une fonction $\psi$ est connue, qui sera détaillée par la suite, permettant de déduire l'état de charge initial de l'énergie de charge mesurée et des conditions de charge. Dans une variante de réalisation où l'étape E16a consiste en une charge nominale, cette étape E16a peut alors placer directement l'accumulateur dans sa position de départ pour une nouvelle itération de l'algorithme A1, rendant inutile l'étape intermédiaire E16b. La fonction $\psi$ est par exemple connue si une caractérisation en charge de l'accumulateur a été réalisée pour les conditions de charge susmentionnées avant la caractérisation en décharge. Selon une variante de réalisation, les étapes de remise en état plein E12b et/ou E16b sont omises si les étapes E12a et/ou E16a comprennent une charge nominale.

Selon une variante de réalisation, l'accumulateur ne se trouve pas dans l'état plein SoE = 1 au début d'une itération i de l'algorithme A1, mais dans un état $SoE_{di}$ différent de l'état plein. C'est notamment le cas pour une réalisation lors de laquelle les étapes E12a et/ou E16a comprennent une charge sous conditions non nominales $X_{E16}$, mais les étapes de remise en état plein E12b et/ou E16b sont omises. Si l'état $SoE_{di}$ est connu par une caractérisation en charge des conditions $X_{E16}$ telle que décrite plus loin, la mesure de l'énergie de décharge pendant l'étape E11 fournit l'énergie disponible $ed(Y_D ; SoE_{0i}=SoE_{di})$ à cet état d'énergie $SoE_{di}$ au lieu de l'énergie disponible à l'état plein $SoE_{0i} = 1$. Il est alors possible de calculer l'énergie disponible $e_{di}$ dans l'accumulateur à la fin de l'étape E15 de la manière suivante : $e_{di} = e_d(Y_D ; SoE_{0i}= SoE_{di}) - E_{Di}$.

Le procédé de caractérisation d'un accumulateur comprend une seconde partie de caractérisation en charge, qui applique les mêmes principes.

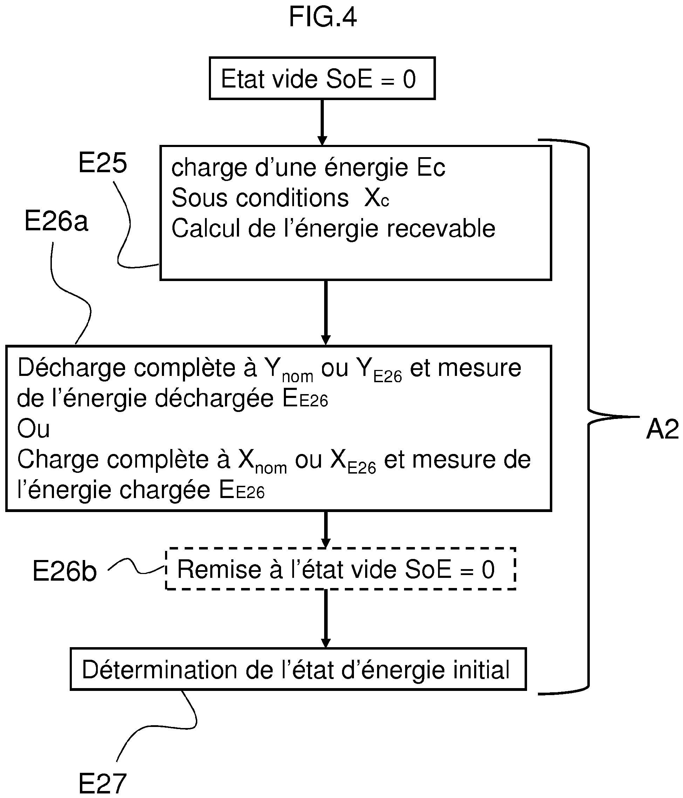

La figure 4 illustre un algorithme A2 mis en oeuvre dans le coeur d'un procédé de caractérisation en charge d'un accumulateur selon un mode de réalisation de l'invention. Cet algorithme A2 est mis en oeuvre à partir d'un état vide de l'accumulateur, caractérisé par un état d'énergie SoE par définition égal à 0. Il comprend les étapes suivantes :

- une charge partielle E25 de l'accumulateur d'une quantité d'énergie $E_C$ prédéfinie, dans les conditions de charge $X_C$ ;
- une charge ou décharge complète E26a dans les conditions nominales $X_{nom}/Y_{nom}$ durant laquelle l'énergie chargée ou déchargée $E_{E26}$ est mesurée ;
- une remise de l'accumulateur dans son état vide par une décharge nominale complète E26b ;
- une détermination de l'état d'énergie initial E27.

En remarque, il est important de constater que cet algorithme A2 est mis en oeuvre avec un état d'énergie initial inconnu de l'accumulateur atteint à la fin de l'étape E26a, qui est calculé a posteriori en dernière étape E27, comme dans le procédé de caractérisation en décharge décrit ci-dessus.

En deuxième remarque, la connaissance de l'énergie nominale de décharge $E_{nomd}$ conditionne le calcul de l'état d'énergie initial lors de l'étape E27. La détermination de cette énergie par un cycle nominal de la batterie doit donc précéder la mise en oeuvre de l'algorithme, si celui comprend l'étape E27 de calcul en ligne. Elle pourrait aussi être effectuée lors de la caractérisation en décharge décrite ci-dessus ou après l'ensemble des mesures, si les calculs sont effectués hors ligne.

En remarque, la décharge nominale de l'étape E26b n'est pas effectuée si l'étape E26a comprend une décharge nominale. Si l'étape E26a comprend une décharge nominale, l'accumulateur est déjà dans l'état plein de départ requis à la fin de l'étape E26a ce qui rend l'étape E26b inutile.

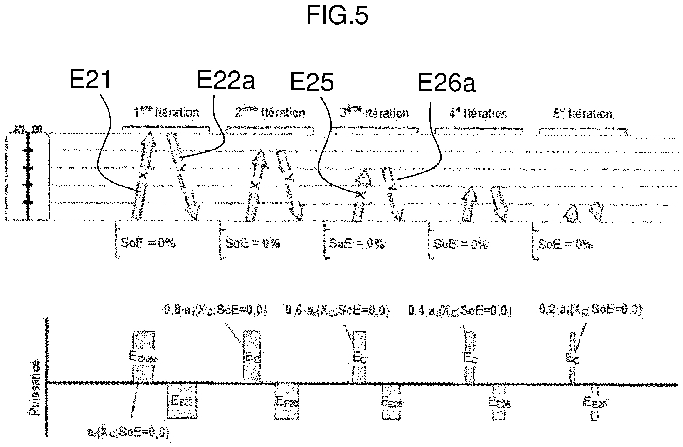

La mise en oeuvre de cet algorithme A2 est illustrée en référence avec la figure 5. Il est d'abord itéré pour obtenir des mesures d'énergie recevable pour plusieurs états d'énergie initial, sans modifier les conditions de charge $X_C$ considérées. La variation de l'état d'énergie initial est réalisée en modifiant l'énergie chargée $E_{Ci}$ à l'étape de charge E25, sans définition préalable de plusieurs états d'énergie initial $SoE_{0i}$ spécifiques puisque ces états sont inconnus au début de l'algorithme A2.

Au moins une fois pendant la mise en oeuvre de la caractérisation en charge, une charge complète E21 est réalisée dans une itération particulière de l'algorithme A2 dans les conditions de charge $X_c$. La mesure de l'énergie chargée $E_{Cvide}$ permet de déterminer l'énergie recevable à partir de l'état vide $a_r(X_c ; SoE_0=0)$ (= $E_{Cvide}$). Puis, une décharge complète E22a est mise en oeuvre dans les conditions de décharge nominale $Y_{nom}$ avec mesure de l'énergie déchargée $E_{E22}$. L'état d'énergie final de la charge $SoE_{fc}$ est déterminé à l'étape E23 selon la formule :

$$SoE_{fc} = e_d(Y_{nom} ; SoE_{fc}) / E_{nomd} = E_{E22} / E_{nomd}$$

En remarque, cette itération particulière de l'algorithme A2 doit précéder les autres itération si le calcul des énergies chargées lors de l'étape E25 se base sur la connaissance de l'énergie $a_r(X_C ; SoE_0=0)$.

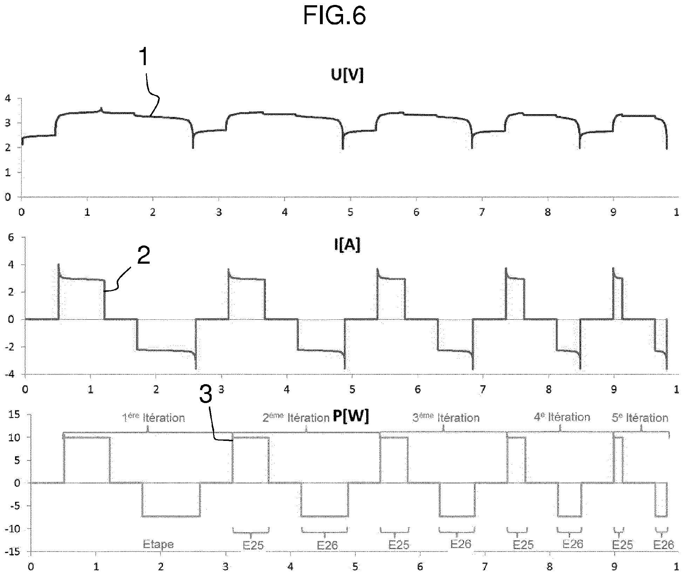

Ensuite, l'algorithme A2 est répété pour différentes valeurs d'énergie $E_{Ci}$ de charge dans l'étape de charge E25, l'indice i étant utilisé pour caractériser l'itération i de répétition de l'algorithme A2. Avantageusement, ces valeurs d'énergie sont réparties de manière homogène entre 0 et l'énergie $a_r(X_C ;SoE_{0i}=0)$ obtenue lors de la première étape. En choisissant à titre d'exemple quatre valeurs d'état d'énergie initial intermédiaire, l'énergie $E_{Ci}$ de charge est alors prédéfinie par les valeurs $0,8*a_r(X_C;SoE_0=0)$, $0,6*a_r(X_C;SoE_0=0)$, $0,4*a_r(X_C;SoE_0=0)$ et $0,2*a_r(X_C;SoE_0=0)$. Ces diffé-rentes valeurs sont utilisées dans les étapes 2 à 5 suivantes, représentées sur la figure 5. En remarque, la figure 6 représente les courbes 1, 2, 3 d'évolution de respectivement la tension U, le courant I et la puissance P de l'accumulateur lors des cinq itérations de l'algorithme A2.

Dans chacune de ces itérations i, on met donc en oeuvre l'algorithme A2.

Durant l'étape E25, une charge de l'accumulateur sous conditions de charge $X_c$ est réalisée, et la quantité d'énergie chargée est mesurée : dès que cette quantité d'énergie atteint le seuil d'énergie $E_{Ci}$ prédéfini, la charge est stoppée. En remarque, en fin de l'étape E25 de cet algorithme, il est possible de calculer l'énergie recevable $a_{ri}$ dans l'accumulateur de la manière suivante : $a_{ri} = a_r(X_C ; SoE_0=0) - E_{Ci}$.

Ensuite, l'étape E26a réalise une décharge complète de l'accumulateur dans des conditions nominales $Y_{nom}$, et l'énergie déchargée $E_{E26i}$ est alors mesurée.

Enfin, il est possible de déterminer à l'étape E27 l'état de charge initial $SoE_{0i}$ de l'itération i par le calcul suivant :

$$SoE_{0i} = e_d(Y_{nom} ; SOE_{0i}) / E_{nomd} = E_{E26i} / E_{nomd}$$

A la fin de chaque itération, nous obtenons bien le multiplet de données recherchées, $X_C$, $SOE_{0i}$, $a_{ri}$.

A la fin de chaque étape du procédé selon la réalisation décrite ci-dessus, l'accumulateur se trouve dans un état vide, requis au début de l'algorithme A2. Les étapes E22b et E26b n'étaient alors pas nécessaires et ont étés omises. Les itérations peuvent ainsi s'enchaîner sans perte de temps.

Le procédé décrit précédemment peut présenter des variantes de réalisation.

Par exemple, les étapes E22a et/ou E26a pourraient consister en une décharge non nominale. Dans ce cas, les étapes E22b et/ou E26b doivent intervenir pour remettre l'accumulateur à son état vide avant de commencer la prochaine itération de l'algorithme A2.

Ensuite, le procédé décrit précédemment est de nouveau répété en modifiant les conditions de charge $X_C$, pour finaliser l'acquisition des multiplets mentionnés dans toutes les dimensions étudiées, notamment en faisant varier les valeurs de puissance de charge $P_{Cj}$, et éventuellement la température. Lorsque toutes ces itérations sont terminées, on obtient alors des multiplets $X_{Cj}$, $SOE_{0i}$, $a_{rij}$.

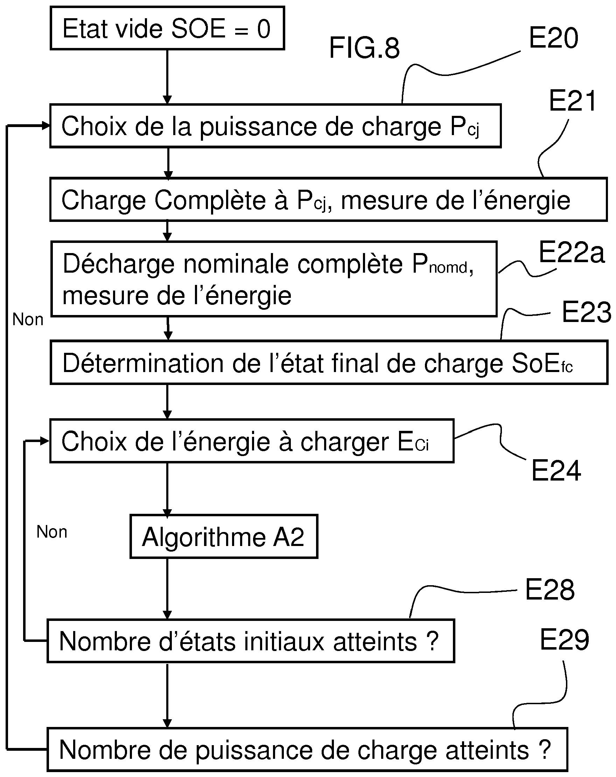

La figure 8 illustre ainsi un tel procédé complet, y exclus la mesure préalable de l'énergie nominale de décharge $E_{nomd}$, dans un mode de réalisation où les conditions de charge $X_{Cj}$ se limitent au paramètre de puissance de charge $P_c$ à titre d'exemple non limitatif. Le procédé met alors en oeuvre les étapes suivantes :

E20 - choix de la puissance de charge $P_{cj}$ ;

E21 - charge complète à la puissance $P_{cj}$ et mesure de l'énergie chargée, qui correspond à l'énergie recevable $a_r(P_{Cj} ;SoE_{01}=0)$;

E22a - décharge nominale complète ;

E23 - Détermination de l'état d'énergie final de la charge $SoE_{fc}$ ;

E24 - choix de l'énergie $E_{ci}$ à charger ;

E25 - E27 - itération de l'algorithme A2 décrit précédemment,

E28 - décompte du nombre d'énergie à charger déjà caractérisée (par exemple par un compteur), c'est-à-dire du nombre d'états de charge initiaux, et comparaison avec le nombre d'états de charge initiaux $n_{SoEc}$ choisi. Si ce nombre n'est pas atteint, on continue les itérations des étapes E24 à E27, sinon

E29 - décompte du nombre de puissance de charge déjà caractérisée (par exemple par un compteur) et comparaison avec le nombre de puissance de charge $n_{Pc}$ choisi. Si ce nombre n'est pas atteint, on retourne à l'étape E20 et on continue les itérations de toutes les étapes précédentes.

Lorsque tous les multiplets mentionnés sont obtenus, directement et/ou indirectement à partir de mesures réelles, le procédé met en oeuvre une étape supplémentaire de détermination d'une fonction $\psi$ permettant de déterminer l'énergie recevable $a_r$ dans l'accumulateur pour tout état d'énergie initial SoE et toutes conditions de charge $X_C$ :

$$a_r = \psi(SOE, X_C).$$

Cette fonction $\psi$ peut être obtenue par toute méthode à partir des valeurs mesurées, comme toute modélisation ou par extrapolation ou interpolation ou par tout traitement mathématique.

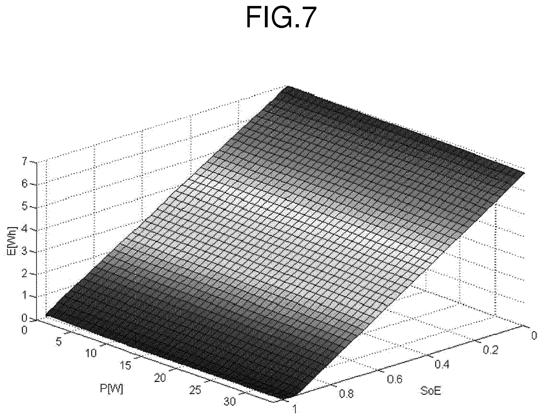

La figure 7 illustre à titre d'exemple la surface obtenue par cette fonction $\psi$ en fonction des trois paramètres $P_{Cj}$, $SoE_{0i}$, $a_{rji}$.

Par analogie avec la fonction $\Phi$ mentionnée ci-dessus, la fonction $\psi$ peut être obtenue pour une plage partielle de la plage d'opération de l'accumulateur en charge afin de l'utiliser dans la détermination des états d'énergie dans l'étape E23 et E27 des itérations suivantes du procédé comme décrit par la suite.

En variante, les étapes E22a et E26a pourraient consister en une charge complète dans des conditions de charge $X_{E22}/X_{E26}$ nominales ou non nominales et on utiliserait un modèle de l'énergie recevable $a_r(X, SoE_0)$ défini par

une fonction $\psi$ tel que :

$$a_r(X_{E26}, SoE_0) = \psi(X_{E26}, SoE_0)$$

On calculerait alors l'état d'énergie final de la charge à l'étape E23 de la manière suivante :

$$SoE_{fc} = \psi^{-1}(X_{E22} ; E_{E22})$$

Ensuite, on calculerait l'état d'énergie initial à l'étape E27 de la manière suivante :

$$SoE_{0i} = \psi^{-1}(X_{E26} ; E_{E26i})$$

Selon une autre variante, les étapes E22a et E26a pourraient consister en une décharge complète dans des conditions de décharge $Y_{E22}/Y_{E26}$ non nominales et on utiliserait un modèle de l'énergie disponible $e_d(Y, SoE_0)$ défini par une fonction $\Phi$ tel que :

$$e_d(Y_{E26}, SoE_0) = \Phi(Y_{E26}, SoE_0)$$

On calculerait alors l'état d'énergie final de la charge à l'étape E23 de la manière suivante :

$$SoE_{fc} = \Phi^{-1}(Y_{E22} ; E_{E22})$$

Ensuite, on calculerait l'état de charge initial à l'étape E27 de la manière suivante :

$$SoE_{0i} = \Phi^{-1}(Y_{E26} ; E_{E26i})$$

Dans ce cas les étapes de décharge E23b et E26b interviendraient pour porter l'accumulateur à son état de départ de l'algorithme A2.

En variante, l'accumulateur se trouve dans un état d'énergie $SoE_{di}$ autre que l'état vide $SoE = 0$ au début des itérations de l'algorithme A2. La mesure d'énergie lors de l'étape E21 donne alors l'énergie recevable à partir de cet état $a_r(X_C ; SoE_0=SoE_{di})$. il est alors possible de calculer l'énergie recevable $a_{ri}$ dans l'accumulateur à la fin de l'étape E25 de la manière suivante : $a_{ri} = a_r(X_C ; SoE_0=SoE_{di}) - E_{Ci}$.

De plus, ce procédé présente aussi l'avantage de permettre le calcul de l'état d'énergie final $SoE_{fc}$ de charge, qui se définit comme l'état d'énergie de l'accumulateur au-dessus duquel il ne peut plus recevoir de l'énergie dans des conditions de charge $X_C$ données. En effet, cette valeur $SoE_{fc}$ est obtenue par la mesure de l'énergie déchargée lors de l'étape E22a de décharge complète dans les conditions nominales. Cela permet d'acquérir plusieurs couples ($SoE_{fc}$ ; $X_C$) à partir desquels une fonction f2 peut être définie par une interpolation : on obtient alors $SoE_{fc} = f2(X_C)$.

Par analogie avec la fonction f, l'inversion de cette fonction f2 permet aussi de déterminer la puissance de charge maximale possible à un état d'énergie SoE donné, au-delà de laquelle l'accumulateur ne peut plus possible de recevoir de l'énergie : $X_C = f2^{-1}(SoE)$.

La figure 9 illustre un procédé complet de caractérisation en décharge d'un accumulateur, dans un mode de réalisation où $Y_{Di}$ se limite à la puissance de décharge $P_{dj}$ et où les étapes E12 et E16a consistent en une charge nominale, ce qui permet d'omettre les étapes E12b et E16b. Le mode de réalisation présenté présuppose la connaissance d'une fonction $\psi$ de l'énergie recevable en charge pour déterminer l'état d'énergie initial dans les étapes E13 et E17. Cette fonction proviendra d'une caractérisation complète ou partielle en charge telle qu'exposée ci-dessus. Le procédé met alors en oeuvre les étapes suivantes :

E10 - choix de la puissance de décharge $P_{dj}$ ;
E11 - décharge complète à la puissance $P_{dj}$ et mesure de l'énergie déchargée, qui correspond à l'énergie disponible $e_d(Y_{Dj} ; SOE_{01}=1)$ ;
E12a - charge nominale complète ;
E13 - détermination de l'état de décharge final $SoE_{fd}$ ;

E14 - choix de l'énergie $E_{di}$ à décharger ;

E15 - E17- itération de l'algorithme A1 décrit précédemment,

E18 - décompte du nombre d'énergies à décharger déjà caractérisées (par exemple par un compteur), c'est-à-dire du nombre d'états de charge initiaux, et comparaison avec le nombre d'états de charge initiaux $n_{SoEd}$ choisi. Si ce nombre n'est pas atteint, on continue les itérations des étapes E14 à E17, sinon

E19 - décompte du nombre de puissance de décharge déjà caractérisée (par exemple par un compteur) et comparaison avec le nombre de puissance de décharge $n_{Pd}$ choisi. Si ce nombre n'est pas atteint, on retourne à l'étape E10 et continue les itérations de toutes les étapes précédentes.

Le graphe supérieur de la figure 10 représente l'évolution de l'état d'énergie de l'accumulateur. La première itération correspond aux étapes de décharge complète E11 et de charge nominale complète E12a mentionnées ci-dessus. Ensuite, les itérations 2 à 5 correspondent aux itérations de l'algorithme A1 mentionnées ci-dessus. L'étape E16a de cet algorithme est mise en oeuvre en choisissant la variante de charge complète dans des conditions nominales, au contraire de la réalisation liée à la figure 3 décrite précédemment. Cette variante de réalisation présente l'avantage d'obtenir l'accumulateur à l'état de pleine charge en fin d'itération, ce qui le rend prêt pour la nouvelle itération, sans nécessiter la mise en oeuvre des étapes E12b et E16b, au contraire de la réalisation de la figure 3.

En remarque, dans cette variante de réalisation, durant l'étape de charge complète (E16a) de l'accumulateur à une puissance de charge $P_{E26}$, une mesure de l'énergie chargée $E_{E16}$ est réalisée, et le calcul de l'état d'énergie initial $SoE_{0i}$ (E17) associé à la puissance de décharge $P_D$ et à l'énergie disponible $e_{di}$ est obtenu de la manière suivante :

$$SoE_{0i} = \psi^{-1}(P_{E26} ; E_{E26}),$$

où $\psi$ est la fonction définie précédemment.

Dans tous ces modes de réalisation, une période de relaxation suffisante est appliquée entre les itérations, selon les préconisations du fabriquant en fonction de la technologie. Par exemple, la période de relaxation sera de 10 minutes pour une batterie Li-ion et supérieure à une heure pour une batterie au plomb.

Comme cela ressort des procédés décrits précédemment, la caractérisation d'un accumulateur est beaucoup plus rapide par le fait qu'elle nécessite moins de cycles complets de charge et/ou décharge. Par exemple, la durée $T_{caracd}$ du procédé de caractérisation en décharge pour une seule condition de décharge lié à l'illustration de la figure 9 peut s'approximer par le calcul :

$$Tcaracd = 2.Tp + (1-SOEkj).\frac{Enomd}{Pnomd} + SOEkj.\frac{Enomd}{Pdi}$$

A comparer au temps pour cette même étape dans l'état de la technique, comme explicité dans la description de l'état de la technique :

$$Tcaracd = \frac{Enomc}{Pnomc} + 3.\ Tp + (1-SOEkj).\frac{Enomd}{Pnomd} + SOEkj.\frac{Enomd}{Pdi}$$

Il est intéressant de noter que le procédé de caractérisation permet un gain de temps notamment par les deux principes suivants :

- on utilise un état d'énergie initial inconnu ;
- on utilise des informations disponibles provenant de caractérisations déjà effectuées sous forme des fonctions $\Phi$ et $\psi$.

En remarque, les calculs d'énergie disponible ou recevable des étapes E15, E25 et les calculs de l'état d'énergie initial des étapes E17, E27 peuvent se faire en temps réel, ou de manière décalée dans le temps, à partir des données mesurées stockées dans une mémoire électronique.

Selon une variante de réalisation, l'algorithme précédent pourrait être implémenté sans prendre en compte tous les $n_{Pd}*n_{SoEd}$ couples mais un échantillon choisi. Par exemple, dans certaines zones où la batterie présente un comportement stable, il serait possible de ne réaliser la mesure que pour un pas sur deux ou sur trois, et effectuer plus de mesures dans des zones plus délicates de fonctionnement de la batterie, soit pour tous les couples de valeurs dans ces zones.

D'autre part, les étapes du procédé de caractérisation ont été mises en oeuvre avec des charges ou décharges à puissance constante. En variante, la puissance pourrait varier. Par exemple, une charge pourrait comprendre une première partie à courant constant jusqu'à un seuil de tension puis une seconde partie à tension constante jusqu'à un seuil de courant.

Le procédé de caractérisation décrit précédemment peut être mis en oeuvre par un dispositif de caractérisation, comprenant de moyens matériel et logiciel pour charger et décharger un accumulateur, dans des conditions imposées et maitrisées. Il comprend aussi un calculateur, comprenant un logiciel qui met en oeuvre les calculs décrits précédemment, et une mémoire électronique (ou non électronique) pour mémoriser les données de caractérisation, obtenues directement ou indirectement par des capteurs de mesure des grandeurs électriques mentionnées.

Le procédé de caractérisation mis en oeuvre permet le suivi de l'état d'énergie d'un accumulateur, sans besoin de tableaux correctifs de l'efficacité de charge.

En effet, si on suppose un accumulateur dans un état d'énergie $SOE_k$, avant de subir sur une certaine période de durée $t_k$ une décharge à puissance constante $P_D$, le procédé suivant peut être mis en oeuvre :

- E36 : l'énergie disponible $E_{dk}$ dans l'accumulateur obéit à $E_{dk} = \Phi(P_D ; SOE_k)$ ;
- on mesure l'énergie fournie par l'accumulateur durant cette durée par le calcul $P_D * t_k$ ;
- E37 : En fin de période, l'énergie disponible dans l'accumulateur peut être calculée par $E_{dk+1} = E_{dk} - P_D * t_k$ ;
- E38 : Ce qui permet d'en déduire l'état d'énergie $SOE_{k+1}$ de l'accumulateur en fin de période par $SOE_{k+1} = \Phi^{-1}(P_D ; E_{dk+1})$.

De manière semblable, le procédé suivant peut être mis en oeuvre pour le suivi de l'état d'énergie d'un accumulateur en période de charge, qui reçoit sur une certaine période de durée $t_k$ une charge à puissance de charge constante $P_c$ :

- E36 : l'énergie recevable $E_{rk}$ dans l'accumulateur obéit à $E_{rk} = \psi(P_c ; SOE_k)$ ;
- on mesure l'énergie reçue par l'accumulateur durant une durée $t_k$ par le calcul $P_c * t_k$ ;
- E37 : En fin de période, l'énergie recevable dans l'accumulateur peut être calculée par $E_{rk+1} = E_{rk} + P_c * t_k$ ;
- E38 : Ce qui permet d'en déduire l'état d'énergie $SOE_{k+1}$ de l'accumulateur en fin de période par $SOE_{k+1} = \psi^{-1}(P_c ; E_{rk+1})$

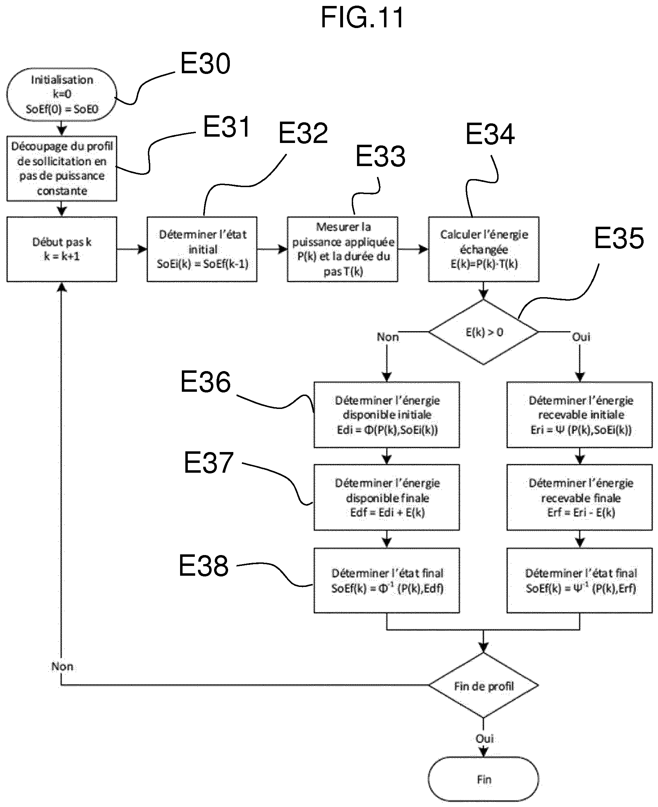

Notamment, le procédé illustré par la figure 11 peut être mis en oeuvre. Ce procédé comprend une étape d'initialisation E30 de l'état d'énergie de l'accumulateur, notamment après une charge ou une décharge complète. On découpe E31 ensuite les périodes d'utilisation de l'accumulateur en périodes de temps où sa sollicitation peut être approximée par une puissance constante en utilisant des méthodes de lissage ou d'autres méthodes mathématiques. Chaque période est identifiée par l'indice k. Puis le procédé comprend l'itération des étapes suivantes :

E32 - calcul de l'état d'énergie initial $SOE_k$ ;
E33 - mesure de la puissance P appliquée sur une durée $t_k$ ;
E34 - calcul de l'énergie échangée par le produit $P * t_k$ ;
E35 - détermination du signe de cette énergie ;

E36 - E38 : on met en oeuvre ces étapes décrites ci-dessus, soit en charge, soit en décharge, en fonction du signe de l'énergie, qui permet de savoir si elle est reçue ou transmise par l'accumulateur ;

Le procédé décrit ci-dessus permet donc bien de suivre facilement l'état d'énergie d'un accumulateur à partir des données de caractérisation définies dans une première phase de caractérisation.

Le procédé de caractérisation précédent permet donc la mise en oeuvre d'un procédé d'estimation de l'énergie disponible d'un accumulateur électrochimique, par exemple par un algorithme itératif, lors de son utilisation dans un système, dans une seconde phase P2. Il est possible d'indiquer l'état d'énergie lors d'une quelconque utilisation de l'accumulateur pourvu qu'une approximation par des périodes à puissance constante soit possible.

Pour cela, un système ou un dispositif intégrant un tel accumulateur peut utiliser des moyens logiciels et/ou matériels (software et/ou hardware), comprenant par exemple une mémoire intégrant les données de caractérisation définies par le procédé de caractérisation précédent, et des calculs en temps réel pour connaître précisément le bilan énergétique du système ou du dispositif. Cette approche est particulièrement avantageuse pour les utilisations de batteries par exemple à bord d'un véhicule automobile électrique, ou pour un dispositif de stockage d'énergie connecté au réseau, ou pour tout type de système de stockage soumis à des sollicitations qui peuvent être approximées de la manière décrite précédemment. Avantageusement, le système comprend une interface homme machine par laquelle il peut communiquer à un utilisateur du système l'état énergétique de son accumulateur, comme l'énergie disponible et/ou l'énergie recevable, et son état d'énergie.

Le concept de l'invention est adapté à tout accumulateur électrochimique, au lithium, ou au nickel, ou au plomb par exemple, que ce soit sur l'accumulateur élémentaire (10 Wh), sur des modules d'accumulateurs en série et/ou en parallèle (100 Wh) ou sur des systèmes complets de modules assemblés aussi en série et/ou en parallèle (de l'ordre de kWh voire de MWh).

Rappel de quelques paramètres utilisés :

| Définition | Symbole |
| --- | --- |
| Point d'état d'énergie initial dans un triplet de la caractérisation | $SoE_{0i}$ |
| Point de puissance dans un triplet de la caractérisation | $P_{di}$ |
| Point d'énergie disponible dans un triplet de la caractérisation | $e_{di}$ ou $e_{dij}$ |
| Point d'énergie recevable dans un triplet de la caractérisation | $a_{ri}$ ou $a_{rij}$ |
| Mesure d'énergie dans un algorithme | $E_C$, $E_D$ |
| Nombre de valeurs de puissance | $n_{Pd}$ ou $n_{Pc}$ |
| Nombre de valeurs de SoE | $n_{SoEd}$ ou $n_{SoEc}$ |
| Nombre de valeurs de température | $n_{Td}$ ou $n_{Tc}$ |
| Nombre total de mesures | $n_{mesd}$ ou $n_{mesc}$ |
| Puissance nominale de décharge | $P_{nomd}$ |
| Puissance nominale de charge | $P_{nomC}$ |
| Energie nominale de décharge | $E_{nomd}$ |
| Energie nominale de charge | $E_{nomc}$ |
| Temps de caractérisation en décharge | $T_{caracd}$ |
| Temps de caractérisation en charge | $T_{caracc}$ |
| Conditions de décharge | Y |
| Conditions de charge | X |
| Puissance de décharge | $P_d$ |
| Puissance de charge | $P_c$ |
| Courant de décharge | $I_d$ |
| Courant de charge | $I_c$ |
| Température de l'accumulateur | $\theta$ |
| Tension de fin de décharge | $U_{fd}$ |
| Courant de fin de décharge | $I_{fd}$ |
| Tension de fin de charge | $U_{fc}$ |
| Conditions de décharge nominale | $Y_{nom}$ |
| Conditions de charge nominale | $X_{nom}$ |
| Capacité nominale | $C_{nom}$ |
| Tension nominale | $U_{nom}$ |
| Temps de décharge nominale | $T_{nomd}$ |
| Etat d'énergie | SoE |
| Energie déchargée lors de l'étape E15 | $E_D$ |
| Energie chargée ou déchargée lors de l'étape E16a | $E_{E16}$ |

(suite)

| Définition | Symbole |
|---|---|
| Energie déchargée lors de l'étape E11 | $E_{Dplein} = e_d(Y_D; SoE = 1)$ |
| Valeurs d'énergie chargée lors de l'étape E15 itérative | $E_{Di}$ |
| Etat final de la charge | $SoE_{fc}$ |
| Conditions de charge lors de l'étape E15 itérative | $X_{Cj}$ |
| Conditions de décharge lors de l'étape E15 itérative | $Y_{Dj}$ |
| Fonction de l'énergie disponible | $e_d = \Phi(P_d, SoE)$ |

**Revendications**

1. Procédé de caractérisation d'un accumulateur électrochimique, comprenant une étape de mesures de multiplets incluant une valeur d'énergie disponible $e_d$ en décharge et/ou d'énergie recevable $a_r$ en charge pour un état d'énergie initial $SoE_0$ et pour respectivement des conditions de décharge $Y_D$, comprenant une grandeur continue qui caractérise la décharge de façon univoque, notamment donnée par la puissance de décharge $P_d$, et des conditions de charge $X_C$, comprenant une grandeur continue qui caractérise la charge de façon univoque, notamment donnée par la puissance de charge $P_c$, **caractérisé en ce qu'**il comprend une itération des étapes suivantes dans l'ordre suivant pour plusieurs valeurs d'énergie $E_{Di}$ prédéfinies pour une caractérisation en décharge de l'accumulateur :

   - décharge partielle (E15) dans des conditions de décharge $Y_D$ d'une énergie $E_{Di}$ à partir de l'état plein de l'accumulateur, et calcul de l'énergie disponible $e_{di}$,
   - charge ou décharge complète (E16a) de l'accumulateur et mesure de l'énergie chargée ou déchargée $E_{E16}$,
   - calcul de l'état d'énergie initial $SOE_{0i}$ (E17) associé aux conditions de décharge $Y_D$ et à l'énergie disponible $e_{di}$ à partir de l'énergie chargée ou déchargée $E_{E16}$;

   ET/OU
   **en ce qu'**il comprend une itération des étapes suivantes dans l'ordre suivant pour plusieurs valeurs d'énergie $E_{Ci}$ prédéfinies pour une caractérisation en charge de l'accumulateur :

   - charge partielle (E25) dans des conditions de charge $X_C$ d'une énergie $E_{Ci}$ à partir d'un état vide de l'accumulateur, et calcul de l'énergie recevable $a_{ri}$,
   - charge ou décharge complète (E26a) de l'accumulateur et mesure de l'énergie chargée ou déchargée $E_{E26}$,
   - calcul de l'état d'énergie initial $SOE_{0i}$ (E27) associé aux conditions de charge $X_C$ et à l'énergie recevable $a_{ri}$ à partir de l'énergie chargée ou déchargée $E_{E26}$.

2. Procédé de caractérisation d'un accumulateur électrochimique selon la revendication précédente, **caractérisé en ce qu'**il comprend les deux étapes préalables suivantes pour une caractérisation en décharge de l'accumulateur :

   - décharge complète (E11) dans les conditions de décharge $Y_D$ de l'accumulateur et mesure de l'énergie déchargée pour en déduire l'énergie disponible $e_d(Y_D ; SoE_0=1)$ pour un état d'énergie initial plein $(SoE_0 = 1)$;
   - charge complète (E12a) dans les conditions nominales ;

   ET/OU
   **en ce qu'**il comprend les deux étapes préalables suivantes pour une caractérisation en charge de l'accumulateur :

   - charge complète (E21) dans les conditions de charge $X_C$ de l'accumulateur et mesure de l'énergie chargée, pour en déduire l'énergie recevable $a_r(X_C ; SoE_0=0)$ pour un état d'énergie nul $(SoE_0 = 0)$;
   - décharge complète (E22a) dans les conditions nominales.

3. Procédé de caractérisation d'un accumulateur électrochimique selon la revendication précédente, **caractérisé en ce qu'**il comprend, pour une caractérisation en décharge de l'accumulateur, suite à la décharge partielle (E15), un calcul de l'énergie disponible $e_{di}$ par le calcul

$$e_{di} = e_d(Y_D \; ; SoE_0 = 1) - E_{Di}$$

ET/OU

**en ce qu'**il comprend, pour une caractérisation en charge de l'accumulateur, suite à la charge partielle (E25), un calcul de l'énergie recevable $a_{ri}$ par le calcul

$$a_{ri} = a_r(X_C \; ; SoE_0 = 0) - E_{Ci}.$$

4. Procédé de caractérisation d'un accumulateur électrochimique selon l'une des revendications précédentes, **caractérisé en ce qu'**il comprend, pour une caractérisation en décharge de l'accumulateur, le calcul de l'état d'énergie initial $SoE_{0i}$ (E17) associé aux conditions de décharge $Y_D$ et à l'énergie disponible $e_{di}$ de la manière suivante :

$$SoE_{0i} = E_{E16} \, / \, E_{nomd}$$

ET/OU

**en ce qu'**il comprend, pour une caractérisation en charge de l'accumulateur, le calcul de l'état d'énergie initial $SoE_{0i}$ (E27) associé aux conditions de charge $X_C$ et à l'énergie recevable $a_{ri}$ de la manière suivante :

$$SoE_{0i} = E_{E26} \, / \, E_{nomd}$$

où $E_{nomd}$ représente l'énergie nominale de l'accumulateur.

5. Procédé de caractérisation d'un accumulateur électrochimique selon l'une des revendications précédentes, **caractérisé en ce qu'**il comprend, pour une caractérisation en décharge de l'accumulateur, le calcul d'une fonction $\Phi$ permettant de relier l'énergie disponible $e_d(Y_D, SoE_0)$ de l'accumulateur aux conditions de décharges $Y_D$ et à un état d'énergie initial $SoE_0$ de l'accumulateur, cette fonction étant définie par $e_d(Y_D, SoE_0) = \Phi(Y_D, SoE_0)$ et étant déterminée par une extrapolation à partir des multiplets mesurés,
ET/OU
**en ce qu'**il comprend, pour une caractérisation en charge de l'accumulateur, le calcul d'une fonction $\psi$ permettant de relier l'énergie recevable $a_r(X_C, SoE_0)$ de l'accumulateur aux conditions de charges $X_C$ et un état d'énergie initial $SoE_0$ de l'accumulateur, cette fonction étant définie par $a_r(X_c, SoE_0) = \psi(X_C \; ; SoE_0)$ et étant déterminée par une extrapolation à partir des multiplets mesurés.

6. Procédé de caractérisation d'un accumulateur électrochimique selon la revendication précédente, **caractérisé en ce que** :

 - pour une caractérisation en décharge de l'accumulateur, il comprend une étape de charge complète (E16a) de l'accumulateur dans des conditions de charge $X_{E16}$ et une mesure de l'énergie chargée $E_{E16}$, et le calcul de l'état d'énergie initial $SoE_{0i}$ (E17) associé aux conditions de décharge $Y_D$ et à l'énergie disponible $e_{di}$ de la manière suivante :

$$SoE_{0i} = \psi^{-1}(X_{E16} \; ; E_{E16}) \; ;$$

 OU
 - pour une caractérisation en décharge de l'accumulateur, il comprend une étape de décharge complète (E16a) de l'accumulateur dans des conditions de décharge $Y_{E16}$ et une mesure de l'énergie déchargée $E_{E16}$, et le calcul de l'état d'énergie initial $SoE_{0i}$ (E17) associé dans des conditions de décharge $Y_D$ et à l'énergie disponible $e_{di}$ de la manière suivante :

$$SoE_{0i} = \Phi^{-1}(Y_{E16} \; ; E_{E16});$$

 OU

- pour une caractérisation en charge de l'accumulateur, il comprend une étape de charge complète (E26a) de l'accumulateur dans des conditions de charge $X_{E26}$ et une mesure de l'énergie chargée $E_{E26}$, et le calcul de l'état d'énergie initial $SoE_{0i}$ (E27) associé aux conditions de charge $X_C$ et à l'énergie disponible $e_{di}$ de la manière suivante :

$$SoE_{0i} = \psi^{-1}(X_{E26} \; ; E_{E26}) \; ;$$

OU

- pour une caractérisation en charge de l'accumulateur, il comprend une étape de décharge complète (E26a) de l'accumulateur dans des conditions de décharge $Y_{E26}$ et une mesure de l'énergie déchargée $E_{E26}$, et le calcul de l'état d'énergie initial $SoE_{0i}$ (E27) associé aux conditions de charge $X_C$ et à l'énergie disponible $e_{di}$ de la manière suivante :

$$SoE_{0i} = \Phi^{-1}(Y_{E26} \; ; E_{E26}).$$

**7.** Procédé de caractérisation d'un accumulateur électrochimique selon l'une des revendications précédentes, **caractérisé en ce que** l'étape de charge ou de décharge complète (E16a ; E26a) de l'accumulateur est réalisée dans des conditions nominales ou non nominales.

**8.** Procédé de caractérisation d'un accumulateur électrochimique selon l'une des revendications 1 à 5, **caractérisé en ce qu'**il comprend :

- lors d'une caractérisation en décharge de l'accumulateur, une étape de décharge complète (E16a) pour atteindre un état d'énergie final $SoE_{fd}$ en décharge au-dessous duquel il n'est plus possible d'obtenir de l'énergie dans les conditions de décharge $Y_D$ données, et **en ce qu'**il comprend une étape de calcul d'une fonction f reliant l'état d'énergie final $SoE_{fd}$ en décharge aux conditions de décharge définie par $SoE_{fd} = f(Y_D)$ ;
OU
- lors d'une caractérisation en charge de l'accumulateur, une étape de charge complète (E26a) pour atteindre un état d'énergie final $SoE_{fc}$ en charge au-dessus duquel il n'est plus possible d'obtenir de l'énergie dans les conditions de charge $Y_C$ données, et **en ce qu'**il comprend une étape de calcul d'une fonction f2 reliant l'état d'énergie final $SoE_{fc}$ en charge aux conditions de charge définie par $SoE_{fc} = f2(Y_C)$.

**9.** Procédé de caractérisation d'un accumulateur électrochimique selon l'une des revendications précédentes, **caractérisé en ce que** :

- lors d'une caractérisation en décharge de l'accumulateur, il comprend les étapes suivantes :

(E10) - choix des conditions de décharge $Y_{Dj}$ ;
(E11) - décharge complète de l'accumulateur à partir de son état plein, dans les conditions de décharge $Y_{Dj}$, et mesure de l'énergie déchargée, qui correspond à l'énergie disponible $e_d(Y_{Dj} ; SoE_{01}=1)$ pour un état initial plein de l'accumulateur ;
(E12a) - charge nominale complète de l'accumulateur ;
(E14) - choix de l'énergie $E_{di}$ à décharger ;
(E15 - E17) - répétition d'un procédé selon l'une des revendications précédentes,
(E18) - décompte du nombre d'énergie à décharger déjà caractérisée et comparaison avec un nombre d'états de charge initiaux $n_{SoEd}$ choisi, et si ce nombre n'est pas atteint, nouvelle itération des étapes précédentes E14 à E17,
(E19) - décompte du nombre de conditions de décharge déjà caractérisées et comparaison avec un nombre de conditions de décharge $n_{Pd}$ choisi et si ce nombre n'est pas atteint, retour à l'étape
(E10) et répétition des étapes précédentes ;

OU
- lors d'une caractérisation en décharge de l'accumulateur, il comprend les étapes suivantes :

(E20) - choix des conditions de charge $X_{Cj}$ ;
(E21) - charge complète de l'accumulateur à partir de son état vide dans les conditions de charge $X_{Cj}$ et mesure de l'énergie chargée,

qui correspond à l'énergie recevable $a_r(X_{Cj} ; SoE_{01}=0)$ pour un état initial vide de l'accumulateur ;

(E22a) - décharge nominale complète ;

(E24) - choix de l'énergie $E_{Ci}$ à charger ;

(E25 - E27) - répétition d'un procédé selon l'une des revendications précédentes,

(E28) - décompte du nombre d'énergie à charger déjà caractérisée et comparaison avec un nombre d'états de charge initiaux $n_{SoEc}$ choisi, et si ce nombre n'est pas atteint, nouvelle itération des étapes E24 à E27,

(E29) - décompte du nombre de conditions de charge déjà caractérisées et comparaison avec un nombre de conditions de charge $n_{Pc}$ choisi et si ce nombre n'est pas atteint, retour à l'étape (E20) et répétition des étapes précédentes.

**10.** Procédé de caractérisation d'un accumulateur électrochimique selon l'une des revendications précédentes, **caractérisé en ce que** :

- lors d'une caractérisation en décharge de l'accumulateur, il comprend une étape préalable de détermination d'un nombre $n_{Pd}$ de valeurs de puissance de décharge $P_{dj}$ supérieur à un et de détermination d'un nombre $n_{SoEd}$ de valeurs d'états d'énergie initial $SoE_{0j}$ supérieur à un, et **en ce qu'**il comprend, pour chaque valeurs de puissance de décharge $P_{dj}$, une sélection de $n_{SoEd}$ valeurs d'énergie $E_{Di}$ à décharger dans l'étape de décharge partielle (E15), réparties de manière homogène entre 0 et l'énergie disponible maximale à la puissance de décharge $P_{dj}$ pour l'état plein de l'accumulateur, ou réparties de manière non homogène ;

ET/OU

- lors d'une caractérisation en charge de l'accumulateur, il comprend une étape préalable de détermination d'un nombre $n_{Pc}$ de valeurs de puissance de charge $P_{cj}$ supérieur à un et de détermination d'un nombre $n_{SoEc}$ de valeurs d'états d'énergie initial $SoE_{0j}$ supérieur à un, et **en ce qu'**il comprend, pour chaque valeurs de puissance de charge $P_{cj}$, une sélection de $n_{SoEc}$ valeurs d'énergie $E_{Ci}$ à charger dans l'étape de charge partielle (E25), réparties de manière homogène entre 0 et l'énergie recevable maximale à la puissance de charge $P_{cj}$ pour l'état vide de l'accumulateur, ou réparties de manière non homogène.

**11.** Procédé d'estimation de l'énergie disponible et/ou recevable d'un accumulateur électrochimique, **caractérisé en ce qu'**il comprend une première phase (P1) de mise en oeuvre du procédé de caractérisation selon l'une des revendications précédentes, puis une seconde phase (P2) d'estimation de l'état d'énergie et/ou de l'énergie disponible et/ou recevable de l'accumulateur à partir des données mémorisées lors de la première phase (P1) de caractérisation.

**12.** Procédé d'estimation de l'énergie disponible et/ou recevable d'un accumulateur électrochimique selon la revendication précédente et la revendication 5, **caractérisé en ce qu'**il comprend l'estimation de l'état d'énergie et de l'énergie disponible et/ou recevable par les étapes :

- lors d'une décharge de l'accumulateur, considération d'une période k de durée $t_k$ pendant laquelle l'accumulateur dans un état d'énergie $SOE_k$ initial subit une décharge à puissance constante $P_D$ :

- (E36) : calcul de l'énergie disponible $E_{dk}$ dans l'accumulateur par la formule $E_{dk}= \Phi (P_D ; SOE_k)$ et mesure de l'énergie restituée par l'accumulateur durant la période k par le calcul $P_D*t_k$ ;

- (E37) : calcul de l'énergie disponible $E_{dk+1}$ dans l'accumulateur en fin de période par la formule

$$E_{dk+1} =  E_{dk} - P_D*t_k ;$$

- (E38) : calcul de l'état d'énergie $SOE_{k+1}$ de l'accumulateur en fin de période par la formule

$$SOE_{k+1} = \Phi^{-1} (P_D ; E_{dk+1}) ;$$

ET/OU

- lors d'une charge de l'accumulateur, considération d'une période k de durée $t_k$ pendant laquelle l'accumulateur dans un état d'énergie $SOE_k$ initial subit une charge à puissance constante $P_c$ :

- (E36) : calcul de l'énergie recevable $E_{rk}$ dans l'accumulateur par la formule $E_{rk} = \psi(P_c ; SOE_k)$ et mesure

de l'énergie reçue par l'accumulateur durant la période k par le calcul $P_c*t_k$ ;

- (E37) : calcul de l'énergie recevable $E_{rk+1}$ dans l'accumulateur en fin de période par la formule $E_{rk+1} = E_{rk} + P_c*t_k$ ;
- (E38) : calcul de l'état d'énergie $SOE_{k+1}$ de l'accumulateur en fin de période par la formule $SOE_{k+1} = \psi^{-1}(P_c ; E_{rk+1})$.

13. Dispositif comprenant au moins un accumulateur électrochimique, **caractérisé en ce qu'**il comprend un moyen d'estimation de l'énergie disponible mettant en oeuvre un procédé selon la revendication précédente.

**Patentansprüche**

1. Verfahren zur Charakterisierung eines elektrochemischen Akkumulators, umfassend einen Schritt von Messungen von Multipletts, die einen Wert von verfügbarer Energie $e_d$ in Entladung und/oder von zulässiger Energie $a_r$ in Ladung für einen Anfangsenergiezustand $SoE_0$ und jeweils für Entladebedingungen $Y_D$, umfassend eine kontinuierliche Größe, die die Entladung eindeutig charakterisiert, insbesondere gegeben durch die Entladeleistung $P_d$, und für Ladebedingungen $X_C$, umfassend eine kontinuierliche Größe, die die Ladung eindeutig charakterisiert, insbesondere gegeben durch die Ladeleistung $P_c$, einschließt, **dadurch gekennzeichnet, dass** es eine Iteration der folgenden Schritte in der folgenden Reihenfolge für mehrere vordefinierte Energiewerte $E_{Di}$ für eine Charakterisierung des Akkumulators in Entladung umfasst:

- teilweise Entladung (E15) unter Entladebedingungen $Y_D$ einer Energie $E_{Di}$ ausgehend vom vollen Zustand des Akkumulators und Berechnung der verfügbaren Energie $e_{di}$,
- vollständige Ladung oder Entladung (E16a) des Akkumulators und Messung der geladenen oder entladenen Energie $E_{E16}$,
- Berechnung des Anfangsenergiezustands $SOE_{0i}$ (E17), der den Entladebedingungen $Y_D$ und der verfügbaren Energie $e_{di}$ zugeordnet ist, auf Basis der geladenen oder entladenen Energie $E_{E16}$;

UND/ODER

dass es eine Iteration der folgenden Schritte in der folgenden Reihenfolge für mehrere vordefinierte Energiewerte $E_{Ci}$ für eine Charakterisierung des Akkumulators in Ladung umfasst:

- teilweise Ladung (E25) unter Ladebedingungen $X_C$ einer Energie $E_{Ci}$ ausgehend vom leeren Zustand des Akkumulators und Berechnung der zulässigen Energie $a_{ri}$,

- vollständige Ladung oder Entladung (E26a) des Akkumulators und Messung der geladenen oder entladenen Energie $E_{E26}$,
- Berechnung des Anfangsenergiezustands $SOE_{0i}$ (E27), der den Ladebedingungen $X_C$ und der zulässigen Energie $a_{ri}$ zugeordnet ist, auf Basis der geladenen oder entladenen Energie $E_{E26}$.

2. Verfahren zur Charakterisierung eines elektrochemischen Akkumulators nach dem vorhergehenden Anspruch, **dadurch gekennzeichnet, dass** es die zwei folgenden vorherigen Schritte für eine Charakterisierung des Akkumulators in Entladung umfasst:

- vollständige Entladung (E11) unter den Entladebedingungen $Y_D$ des Akkumulators und Messung der entladenen Energie, um davon die verfügbare Energie $e_d(Y_D; SoE_0=1)$ für einen vollen Anfangsenergiezustand ($SoE_0=1$) abzuleiten;
- vollständige Ladung (E12a) unter den Nominalbedingungen;

UND/ODER

dass es die zwei folgenden vorherigen Schritte für eine Charakterisierung des Akkumulators in Ladung umfasst:

- vollständige Ladung (E21) unter den Ladebedingungen $X_C$ des Akkumulators und Messung der geladenen Energie, um davon die zulässige Energie $a_r(X_C; SoE_0=0)$ für einen Anfangsenergiezustand gleich Null ($SoE_0=0$) abzuleiten;
- vollständige Entladung (E22a) unter den Nominalbedingungen.

3. Verfahren zur Charakterisierung eines elektrochemischen Akkumulators nach dem vorhergehenden Anspruch, **da-**

**durch gekennzeichnet, dass** es für eine Charakterisierung des Akkumulators in Entladung nach der teilweisen Entladung (E15) eine Berechnung der verfügbaren Energie $e_{di}$ durch folgende Berechnung umfasst:

$$e_{di} = e_d(Y_D; \; SoE_0=1) - E_{Di}$$

UND/ODER

dass es für eine Charakterisierung des Akkumulators in Ladung nach der teilweisen Ladung (E25) eine Berechnung der zulässigen Energie $a_{ri}$ durch folgende Berechnung umfasst:

$$ar_i = a_r(X_C; \; SoE_0=0) - E_{Ci}.$$

4. Verfahren zur Charakterisierung eines elektrochemischen Akkumulators nach einem der vorhergehenden Ansprüche, **dadurch gekennzeichnet, dass** es für eine Charakterisierung des Akkumulators in Entladung die Berechnung des Anfangsenergiezustandes $SoE_{0i}$ (E17), der den Entladebedingungen $Y_D$ und der verfügbaren Energie $e_{di}$ zugeordnet ist, folgendermaßen umfasst:

$$SoE_{0i} = E_{E16}/E_{nomd}$$

UND/ODER

dass es für eine Charakterisierung des Akkumulators in Ladung die Berechnung des Anfangsenergiezustandes $SoE_{0i}$ (E27), der den Ladebedingungen $X_C$ und der zulässigen Energie $a_{ri}$ zugeordnet ist, folgendermaßen umfasst:
$SoE_{0i} = E_{E26}/E_{nomd}$
wobei $E_{nomd}$ die Nominalenergie des Akkumulators darstellt.

5. Verfahren zur Charakterisierung eines elektrochemischen Akkumulators nach einem der vorhergehenden Ansprüche, **dadurch gekennzeichnet, dass** er für eine Charakterisierung des Akkumulators in Entladung die Berechnung einer Funktion $\Phi$ umfasst, die es ermöglicht die verfügbare Energie $e_d(Y_D, SoE_0)$ des Akkumulators mit den Entladebedingungen $Y_D$ und einem Anfangsenergiezustand $SoE_0$ des Akkumulators zu verbinden, wobei diese Funktion durch $e_d(Y_D, SoE_0) = \Phi(Y_D, SoE_0)$ definiert ist und durch eine Extrapolation aus den gemessenen Multipletts bestimmt wird,
UND/ODER
dass er für eine Charakterisierung des Akkumulators in Ladung die Berechnung einer Funktion $\Psi$ umfasst, die es ermöglicht die zulässige Energie $a_r(X_C, SoE_0)$ des Akkumulators mit den Ladebedingungen $X_C$ und einem Anfangsenergiezustand $SoE_0$ des Akkumulators zu verbinden, wobei diese Funktion durch $a_r(X_C, SoE_0) = \Psi(X_C, SoE_0)$ definiert ist und durch eine Extrapolation aus den gemessenen Multipletts bestimmt wird.

6. Verfahren zur Charakterisierung eines elektrochemischen Akkumulators nach dem vorhergehenden Anspruch, **dadurch gekennzeichnet, dass**:

- für eine Charakterisierung des Akkumulators in Entladung es einen Schritt der vollständigen Ladung (E16a) des Akkumulators unter Ladebedingungen $X_{E16}$ und eine Messung der geladenen Energie $E_{E16}$ und die Berechnung des Anfangsenergiezustands $SoE_{0i}$ (E17), der den Entladebedingungen $Y_D$ und der verfügbaren Energie $e_{di}$ zugeordnet ist, folgendermaßen umfasst:

$$SoE_{0i} = \Psi^{-1}(X_{E16}; \; E_{E16});$$

ODER

- für eine Charakterisierung des Akkumulators in Entladung es einen Schritt der vollständigen Entladung (E16a) des Akkumulators unter Ladebedingungen $Y_{E16}$ und eine Messung der entladenen Energie $E_{E16}$ und die Berechnung des Anfangsenergiezustands $SoE_{0i}$ (E17), der den Entladebedingungen $Y_D$ und der verfügbaren Energie $e_{di}$ zugeordnet ist, folgendermaßen umfasst:

$$SoE_{0i} = \Phi^{-1}(Y_{E16}; \; E_{E16});$$

ODER

- für eine Charakterisierung des Akkumulators in Ladung es einen Schritt der vollständigen Ladung (E26a) des Akkumulators unter Ladebedingungen $X_{E26}$ und eine Messung der geladenen Energie $E_{E26}$ und die Berechnung des Anfangsenergiezustands $SoE_{0i}$ (E27), der den Entladebedingungen $X_C$ und der verfügbaren Energie $e_{di}$ zugeordnet ist, folgendermaßen umfasst:

$$SoE_{0i} = \Psi^{-1} (X_{E26}; E_{E26});$$

ODER

- für eine Charakterisierung des Akkumulators in Ladung es einen Schritt der vollständigen Entladung (E26a) des Akkumulators unter Entladebedingungen $Y_{E26}$ und eine Messung der entladenen Energie $E_{E26}$ und die Berechnung des Anfangsenergiezustands $SoE_{0i}$ (E27), der den Entladebedingungen $X_C$ und der verfügbaren Energie $e_{di}$ zugeordnet ist, folgendermaßen umfasst:

$$SoE_{0i} = \Phi^{-1} (Y_{E26}; E_{E26}).$$

7. Verfahren zur Charakterisierung eines elektrochemischen Akkumulators nach einem der vorhergehenden Ansprüche, **dadurch gekennzeichnet, dass** der Schritt der vollständigen Ladung oder Entladung (E16a; E26a) des Akkumulators unter Nominal- oder Nicht-Nominalbedingungen durchgeführt wird.

8. Verfahren zur Charakterisierung eines elektrochemischen Akkumulators nach einem der Ansprüche 1 bis 5, **dadurch gekennzeichnet, dass** es umfasst:

- bei einer Charakterisierung des Akkumulators in vollständiger Entladung einen Schritt der vollständigen Entladung (E16a), um einen Endenergiezustand $SoE_{fd}$ in Entladung zu erreichen, unter dem es nicht mehr möglich ist, Energie unter den gegebenen Entladebedingungen $Y_D$ zu erhalten, und dass es einen Schritt der Berechnung einer Funktion f umfasst, die den Endenergiezustand $SoE_{fd}$ in Entladung mit den Entladebedingungen verbindet, definiert durch

$$SoE_{fd} = f(Y_D);$$

ODER

- bei einer Charakterisierung des Akkumulators in vollständiger Ladung einen Schritt der vollständigen Ladung (E26a), um einen Endenergiezustand $SoE_{fc}$ in Ladung zu erreichen, über dem es nicht mehr möglich ist, Energie unter den gegebenen Ladebedingungen $Y_C$ zu erhalten, und dass es einen Schritt der Berechnung einer Funktion f2 umfasst, die den Endenergiezustand $SoE_{fc}$ in Ladung mit den Ladebedingungen verbindet, definiert durch

$$SoE_{fc} = f2(Y_C).$$

9. Verfahren zur Charakterisierung eines elektrochemischen Akkumulators nach einem der vorhergehenden Ansprüche, **dadurch gekennzeichnet, dass**:

- bei einer Charakterisierung des Akkumulators in Entladung es die folgenden Schritte umfasst:

(E10) - Wahl der Entladebedingungen $Y_{Dj}$;
(E11) - vollständige Entladung des Akkumulators auf Basis seines vollen Zustands unter den Entladebedingungen $Y_{Dj}$ und Messung der entladenen Energie, die der verfügbaren Energie $e_d(Y_{Dj}; SoE_{01}=1)$ für einen vollen Anfangszustand des Akkumulators entspricht;
(E12a) - vollständige Nominalladung des Akkumulators;
(E14) - Wahl der zu entladenden Energie $E_{di}$;
(E15-E17) - Wiederholung eines Verfahrens nach einem der vorhergehenden Ansprüche,
(E18) - Zählen der bereits charakterisierten zu entladenden Energiezahl und Vergleich mit einer gewählten Zahl von Anfangsladezuständen $n_{SoEd}$, und wenn diese Zahl nicht erreicht ist, neue Iteration der vorhergehenden Schritte E14 bis E17,

(E19) - Zählen der Zahl von bereits charakterisierten Entladebedingungen und Vergleich mit einer gewählten Zahl von Entladebedingungen $n_{Pd}$, und wenn diese Zahl nicht erreicht ist, Rückkehr zu Schritt (E10) und Wiederholung der vorhergehenden Schritte;

ODER
- bei einer Charakterisierung des Akkumulators in Entladung es die folgenden Schritte umfasst:

(E20) - Wahl der Ladebedingungen $X_{Cj}$;
(E21) - vollständige Ladung des Akkumulators auf Basis seines leeren Zustands unter den Ladebedingungen $x_{cj}$ und Messung der geladenen Energie, die der zulässigen Energie $a_r(X_{Cj}; SoE_{01}=0)$ für einen leeren Anfangszustand des Akkumulators entspricht;
(E22a) - vollständige Nominalentladung des Akkumulators;
(E24) - Wahl der zu ladenden Energie $E_{Ci}$;
(E25-E27) - Wiederholung eines Verfahrens nach einem der vorhergehenden Ansprüche,
(E28) - Zählen der bereits charakterisierten zu ladenden Energiezahl und Vergleich mit einer gewählten Zahl von Anfangsladezuständen $n_{SoEc}$, und wenn diese Zahl nicht erreicht ist, neue Iteration der vorhergehenden Schritte E24 bis E27,
(E29) - Zählen der Zahl von bereits charakterisierten Ladebedingungen und Vergleich mit einer gewählten Zahl von Ladebedingungen $n_{Pc}$, und wenn diese Zahl nicht erreicht ist, Rückkehr zu Schritt (E20) und Wiederholung der vorhergehenden Schritte.

10. Verfahren zur Charakterisierung eines elektrochemischen Akkumulators nach einem der vorhergehenden Ansprüche, **dadurch gekennzeichnet, dass**:

- es bei einer Charakterisierung des Akkumulators in Entladung einen vorherigen Schritt der Bestimmung einer Zahl $n_{Pd}$ von Werten einer Entladeleistung $P_{dj}$ größer als eins und der Bestimmung einer Zahl $n_{SoEd}$ von Werten eines Anfangsenergiezustands $SoE_{0j}$ größer als eines umfasst, und dass es für jeden Entladeleistungswert $P_{dj}$ eine Auswahl von $n_{SoEd}$ Energiewerten $E_{Di}$, die in dem Schritt der teilweisen Entladung (E15) zu entladen sind, die homogen zwischen 0 und der maximal verfügbaren Energie bei der Entladeleistung $P_{dj}$ für den vollen Zustand des Akkumulators verteilt sind oder nicht homogen verteilt sind, umfasst;
UND/ODER
- es bei einer Charakterisierung des Akkumulators in Ladung einen vorherigen Schritt der Bestimmung einer Zahl $n_{Pc}$ von Werten einer Ladeleistung $P_{cj}$ größer als eins und der Bestimmung einer Zahl $n_{SoEc}$ von Werten eines Anfangsenergiezustands $SoE_{0j}$ größer als eines umfasst, und dass es für jeden Ladeleistungswert $P_{cj}$ eine Auswahl von $n_{SoEc}$ Energiewerten $E_{Ci}$, die in dem Schritt der teilweisen Ladung (E25) zu laden sind, die homogen zwischen 0 und der maximal zulässigen Energie bei der Ladeleistung $P_{cj}$ für den leeren Zustand des Akkumulators verteilt sind oder nicht homogen verteilt sind, umfasst.

11. Verfahren zur Schätzung der verfügbaren und/oder zulässigen Energie eines elektrochemischen Akkumulators, **dadurch gekennzeichnet, dass** es eine erste Phase (P1) des Einsatzes des Charakterisierungsverfahrens nach einem der vorhergehenden Ansprüche, dann eine zweite Phase (P2) der Schätzung des Energiezustands und/oder der verfügbaren und/oder zulässigen Energie des Akkumulators auf Basis der in der ersten Charakterisierungsphase (P1) gespeicherten Daten umfasst.

12. Verfahren zur Schätzung der verfügbaren und/oder zulässigen Energie eines elektrochemischen Akkumulators nach dem vorhergehenden Anspruch und Anspruch 5, **dadurch gekennzeichnet, dass** es die Schätzung des Energiezustands und der verfügbaren und/oder zulässigen Energie durch die folgenden Schritte umfasst:

- bei einer Entladung des Akkumulators Betrachtung einer Periode k der Dauer $t_k$, während der der Akkumulator in einem Anfangsenergiezustand $SOE_k$ einer Entladung bei konstanter Leistung $P_D$ unterliegt:

- (E36): Berechnung der verfügbaren Energie $E_{dk}$ in dem Akkumulator durch die Formel $E_{dk} = \Phi (P_D; SOE_k)$ und Messung der vom Akkumulator wiedergegebenen Energie während der Periode k durch die Berechnung $P_D{}^*t_k$;
- (E37): Berechnung der in dem Akkumulator verfügbaren Energie $E_{dk+1}$ am Ende der Periode durch die Formel

$$E_{dk+1} = E_{dk} - P_D * t_k;$$

- (E38): Berechnung des Energiezustands $SOE_{k+1}$ des Akkumulators am Ende der Periode durch die Formel $SOE_{k+1} = \Phi^{-1}(P_D; E_{dk+1})$;

UND/ODER

- bei einer Ladung des Akkumulators Betrachtung einer Periode k der Dauer $t_k$, während der der Akkumulator in einem Anfangsenergiezustand $SOE_k$ einer Ladung bei konstanter Leistung $P_C$ unterliegt:

- (E36) : Berechnung der zulässigen Energie $E_{rk}$ in dem Akkumulator durch die Formel $E_{rk} = \Psi (P_C; SOE_k)$ und Messung der vom Akkumulator empfangenen Energie während der Periode k durch die Berechnung $P_C * t_k$;
- (E37) : Berechnung der in dem Akkumulator zulässigen Energie $E_{rk+1}$ am Ende der Periode durch die Formel

$$E_{rk+1} = E_{rk} - P_C * t_k;$$

- (E38): Berechnung des Energiezustands $SOE_{k+1}$ des Akkumulators am Ende der Periode durch die Formel $SOE_{k+1} = \Psi^{-1}(P_C; E_{rk+1})$.

**13.** Vorrichtung, umfassend mindestens einen elektrochemischen Akkumulator, **dadurch gekennzeichnet, dass** er ein Mittel zur Schätzung der verfügbaren Energie umfasst, das ein Verfahren nach dem vorhergehenden Anspruch einsetzt.

## Claims

**1.** Method for characterizing an electrochemical accumulator, comprising a step of measurements of multiplets including a value of energy available $e_d$ while discharging and/or of energy receivable $a_r$ while charging for an initial energy state $SoE_0$ and for respectively discharging conditions $Y_D$, comprising a continuous magnitude which characterizes the discharging in a one-to-one manner, in particular given by the discharging power $P_d$, and charging conditions $X_C$, comprising a continuous magnitude which characterizes the charging in a one-to-one manner, in particular given by the charging power $P_C$, **characterized in that** it comprises an iteration of the following steps in the following order for several values of energy $E_{Di}$ predefined for a characterization while discharging of the accumulator:

- partial discharging (E15) under discharging conditions $Y_D$ of an energy $E_{Di}$ from the full state of the accumulator, and calculation of the energy available $e_{di}$,
- complete charging or discharging (E16a) of the accumulator and measurement of the energy charged or discharged $E_{E16}$,
- calculation of the initial energy state $SOE_{0i}$ (E17) associated with the discharging conditions $Y_D$ and with the energy available $e_{di}$ on the basis of the energy charged or discharged $E_{E16}$;

AND/OR
**in that** it comprises an iteration of the following steps in the following order for several values of energy $E_{Ci}$ predefined for a characterization while charging of the accumulator:

- partial charging (E25) under charging conditions $X_C$ of an energy $E_{Ci}$ from an empty state of the accumulator, and calculation of the energy receivable $a_{ri}$,
- complete charging or discharging (E26a) of the accumulator and measurement of the energy charged or discharged $E_{E26}$,
- calculation of the initial energy state $SOE_{0i}$ (E27) associated with the charging conditions $X_C$ and with the energy receivable $a_{ri}$ on the basis of the energy charged or discharged $E_{E26}$.

**2.** Method for characterizing an electrochemical accumulator according to the preceding claim, **characterized in that** it comprises the following two prior steps for a characterization while discharging of the accumulator:

- complete discharging (E11) under the discharging conditions $Y_D$ of the accumulator and measurement of the energy discharged so as to deduce therefrom the energy available $e_d(Y_D; SoE_0=1)$ for a full initial energy state ($SoE_0= 1$);
- complete charging (E12a) under the nominal conditions;

AND/OR
**in that** it comprises the following two prior steps for a characterization while charging of the accumulator:

- complete charging (E21) under the charging conditions $X_C$ of the accumulator and measurement of the energy charged, so as to deduce therefrom the energy receivable $a_r(X_c; SoE_0=0)$ for a zero energy state ($SoE_0= 0$);
- complete discharging (E22a) under the nominal conditions.

3. Method for characterizing an electrochemical accumulator according to the preceding claim, **characterized in that** it comprises, for a characterization while discharging of the accumulator, subsequent to the partial discharging (E15), a calculation of the energy available $e_{di}$ through the calculation

$$e_{di} = e_d(Y_D; SoE_0=1) - E_{Di}$$

AND/OR
**in that** it comprises, for a characterization while charging of the accumulator, subsequent to the partial charging (E25), a calculation of the energy receivable $a_{ri}$ through the calculation

$$a_{ri} = a_r(X_c; SoE_0=0) - E_{Ci}.$$

4. Method for characterizing an electrochemical accumulator according to one of the preceding claims, **characterized in that** it comprises, for a characterization while discharging of the accumulator, the calculation of the initial energy state $SoE_{0i}$ (E17) associated with the discharging conditions $Y_D$ and with the energy available $e_{di}$ in the following manner: $SoE_{0i} = E_{E16}/E_{nomd}$ AND/OR
**in that** it comprises, for a characterization while charging of the accumulator, the calculation of the initial energy state $SoE_{0i}$ (E27) associated with the charging conditions $X_c$ and with the energy receivable $a_{ri}$ in the following manner: $SoE_{0i} = E_{E26}/E_{nomd}$
where $E_{nomd}$ represents the nominal energy of the accumulator.

5. Method for characterizing an electrochemical accumulator according to one of the preceding claims, **characterized in that** it comprises, for a characterization while discharging of the accumulator, the calculation of a function $\Phi$ making it possible to link the energy available $e_d(Y_D, SoE_0)$ of the accumulator to the conditions of dischargings $Y_D$ and to an initial energy state $SoE_0$ of the accumulator, this function being defined by $e_d(Y_D, SoE_0) = \Phi(Y_D, SoE_0)$ and being determined by an extrapolation on the basis of the measured multiplets,
AND/OR
**in that** it comprises, for a characterization while charging of the accumulator, the calculation of a function $\psi$ making it possible to link the energy receivable $a_r(X_c, SoE_0)$ of the accumulator to the conditions of chargings $X_c$ and an initial energy state $SoE_0$ of the accumulator, this function being defined by $a_r(X_c, SoE_0) = \psi(X_c; SoE_0)$ and being determined by an extrapolation on the basis of the measured multiplets.

6. Method for characterizing an electrochemical accumulator according to the preceding claim, **characterized in that**:

- for a characterization while discharging of the accumulator, it comprises a step of complete charging (E16a) of the accumulator under charging conditions $X_{E16}$ and a measurement of the energy charged $E_{E16}$, and the calculation of the initial energy state $SoE_{0i}$ (E17) associated with the discharging conditions $Y_D$ and with the energy available $e_{di}$ in the following manner:

$$SoE_{0i} = \psi^{-1}(X_{E16}; E_{E16});$$

OR
- for a characterization while discharging of the accumulator, it comprises a step of complete discharging (E16a) of the accumulator under discharging conditions $Y_{E16}$ and a measurement of the energy discharged $E_{E16}$, and the calculation of the associated initial energy state $SoE_{0i}$ (E17) under discharging conditions $Y_D$ and with the energy available $e_{di}$ in the following manner: $SoE_{0i} = \Phi^{-1}(Y_{E16}; E_{E16})$ ;
OR

- for a characterization while charging of the accumulator, it comprises a step of complete charging (E26a) of the accumulator under charging conditions $X_{E26}$ and a measurement of the energy charged $E_{E26}$, and the calculation of the initial energy state $SoE_{0i}$ (E27) associated with the charging conditions $X_C$ and with the energy available $e_{di}$ in the following manner:

$$SoE_{0i} = \psi^{-1}(X_{E26}; E_{E26}) ;$$

OR

- for a characterization while charging of the accumulator, it comprises a step of complete discharging (E26a) of the accumulator under discharging conditions $Y_{E26}$ and a measurement of the energy discharged $E_{E26}$, and the calculation of the initial energy state $SoE_{0i}$ (E27) associated with the charging conditions $X_c$ and with the energy available $e_{di}$ in the following manner:

$$SoE_{0i} = \Phi^{-1}(Y_{E26}; E_{E26}) .$$

7. Method for characterizing an electrochemical accumulator according to one of the preceding claims, **characterized in that** the step of complete charging or discharging (E16a; E26a) of the accumulator is carried out under nominal or non-nominal conditions.

8. Method for characterizing an electrochemical accumulator according to one of Claims 1 to 5, **characterized in that** it comprises:

- during a characterization while discharging of the accumulator, a step of complete discharging (E16a) to reach a final energy state $SoE_{fd}$ while discharging below which it is no longer possible to obtain energy under the given discharging conditions $Y_D$, and **in that** it comprises a step of calculating a function f linking the final energy state $SoE_{fd}$ while discharging to the discharging conditions defined by $SoE_{fd} = f(Y_D)$;
OR
- during a characterization while charging of the accumulator, a step of complete charging (E26a) to reach a final energy state $SoE_{fc}$ while charging above which it is no longer possible to obtain energy under the given charging conditions $Y_c$, and **in that** it comprises a step of calculating a function f2 linking the final energy state $SoE_{fc}$ while charging to the charging conditions defined by $SoE_{fc} = f2(Y_c)$.

9. Method for characterizing an electrochemical accumulator according to one of the preceding claims, **characterized in that**:

- during a characterization while discharging of the accumulator, it comprises the following steps:

(E10) - choosing of the discharging conditions $Y_{Dj}$;
(E11) - complete discharging of the accumulator from its full state, under the discharging conditions $Y_{Dj}$, and measurement of the energy discharged, which corresponds to the energy available $e_d(Y_{Dj}; SoE_{01}=1)$ for a full initial state of the accumulator;
(E12a) - complete nominal charging of the accumulator;
(E14) - choosing of the energy $E_{di}$ to be discharged;
(E15 - E17) - repeating of a method according to one of the preceding claims,
(E18) - counting down of the number of energy to be discharged already characterized and comparing with a chosen number of initial charge states $n_{SoEd}$, and if this number is not reached, new iteration of the previous steps E14 to E17,
(E19) - counting down of the number of discharging conditions already characterized and comparing with a chosen number of discharging conditions $n_{Pd}$ and if this number is not reached, returning to step (E10) and repeating of the previous steps;

OR

- during a characterization while discharging of the accumulator, it comprises the following steps:

(E20) - choosing of the charging conditions $X_{Cj}$;
(E21) - complete charging of the accumulator from its empty state under the charging conditions $X_{Cj}$ and measurement of the energy charged, which corresponds to the energy receivable $a_r(X_{Cj}; SoE_{01}=0)$ for an empty initial state of the accumulator;
(E22a) - complete nominal discharging;
(E24) - choosing of the energy $E_{Ci}$ to be charged;
(E25 - E27) - repeating of a method according to one of the preceding claims,
(E28) - counting down of the number of energy to be charged already characterized and comparing with a chosen number of initial charge states $n_{SoEc}$, and if this number is not reached, new iteration of steps E24 to E27,
(E29) - counting down of the number of charging conditions already characterized and comparing with a chosen number of charging conditions $n_{Pc}$ and if this number is not reached, returning to step (E20) and repeating of the previous steps.

10. Method for characterizing an electrochemical accumulator according to one of the preceding claims, **characterized in that**:

- during a characterization while discharging of the accumulator, it comprises a prior step of determining a number $n_{Pd}$ greater than one of discharging power values $P_{dj}$ and of determining a number $n_{SoEd}$ greater than one of values of initial energy states $SoE_{0j}$, and **in that** it comprises, for each discharging power values $P_{dj}$, a selecting of $n_{SoEd}$ values of energy $E_{Di}$ to be discharged in the step of partial discharging (E15), which are distributed in a homogeneous manner between 0 and the maximum energy available at the discharging power $P_{dj}$ for the full state of the accumulator, or are distributed in a non-homogeneous manner;
AND/OR
- during a characterization while charging of the accumulator, it comprises a prior step of determining a number $n_{Pc}$ greater than one of charging power values $P_{Cj}$ and of determining a number $n_{SoEc}$ greater than one of values of initial energy states $SoE_{0j}$, and **in that** it comprises, for each charging power values $P_{cj}$, a selecting of $n_{SoEc}$ values of energy $E_{Ci}$ to be charged in the step of partial charging (E25), which are distributed in a homogeneous manner between 0 and the maximum energy receivable at the charging power $P_{cj}$ for the empty state of the accumulator, or are distributed in a non-homogeneous manner.

11. Method for estimating the energy available and/or receivable of an electrochemical accumulator, **characterized in that** it comprises a first phase (P1) of implementing the characterization method according to one of the preceding claims, and then a second phase (P2) of estimating the energy state and/or the energy available and/or receivable of the accumulator on the basis of the data stored during the first characterization phase (P1).

12. Method for estimating the energy available and/or receivable of an electrochemical accumulator according to the preceding claim and Claim 5, **characterized in that** it comprises the estimation of the energy state and of the energy available and/or receivable by the steps:

- during a discharging of the accumulator, consideration of a period k of duration $t_k$ during which the accumulator in an initial energy state $SOE_k$ undergoes a discharging at constant power $P_D$:

- (E36) : calculation of the energy available $E_{dk}$ in the accumulator through the formula $E_{dk} = \Phi(P_D; SOE_k)$ and measurement of the energy yielded by the accumulator during the period k through the calculation $P_D{}^*t_k$;
- (E37): calculation of the energy available $E_{dk+1}$ in the accumulator at the end of the period through the formula

$$E_{dk+1} = E_{dk} - P_D{}^*t_k;$$

- (E38): calculation of the energy state $SOE_{k+1}$ of the accumulator at the end of the period through the formula

$$SOE_{k+1} = \Phi^{-1}(P_D; E_{dk+1});$$

AND/OR

- during a charging of the accumulator, consideration of a period k of duration $t_k$ during which the accumulator in an initial energy state $SOE_k$ undergoes a charging at constant power $P_c$:

- (E36) : calculation of the energy receivable $E_{rk}$ in the accumulator through the formula $E_{rk} = \psi(P_c; SOE_k)$ and measurement of the energy received by the accumulator during the period k through the calculation $P_C*t_k$;

- (E37): calculation of the energy receivable $E_{rk+1}$ in the accumulator at the end of the period through the formula

$$E_{rk+1} = E_{rk} + P_c * t_k;$$

- (E38): calculation of the energy state $SOE_{k+1}$ of the accumulator at the end of the period through the formula

$$SOE_{k+1} = \psi^{-1}(P_c; E_{rk+1}).$$

13. Device comprising at least one electrochemical accumulator, **characterized in that** it comprises a means for estimating the energy available implementing a method according to the preceding claim.

## FIG.1a

| Puissance de charge [W] | Etat d'énergie initial | | | | | |
|---|---|---|---|---|---|---|
| | 0% | 20% | 40% | 60% | 80% | 100% |
| 0.00 | 7.47 | 6.59 | 4.40 | 2.93 | 1.49 | 0 |
| 2.56 | 7.50 | 6.61 | 4.41 | 2.94 | 1.49 | 0 |
| 5.13 | 7.53 | 6.64 | 4.43 | 2.95 | 1.50 | 0 |
| 10.25 | 7.58 | 6.70 | 4.47 | 2.98 | 1.50 | 0 |
| 20.50 | 7.70 | 6.81 | 4.54 | 3.02 | 1.52 | 0 |
| 4100 | 7.93 | 7.04 | 4.67 | 3.11 | 1.56 | 0 |

## FIG.1b

| Puissance de charge [W] | Etat d'énergie initial | | | | | |
|---|---|---|---|---|---|---|
| | 0% | 20% | 40% | 60% | 80% | 100% |
| 0.00 | 1.003 | 1.003 | 1.002 | 1.001 | 1.001 | 1.000 |
| 2.56 | 1.003 | 1.003 | 1.002 | 1.001 | 1.001 | 1.000 |
| 5.13 | 1.003 | 1.003 | 1.002 | 1.001 | 1.001 | 1.000 |
| 10.25 | 1.003 | 1.003 | 1.002 | 1.001 | 1.001 | 1.000 |
| 20.50 | 1.003 | 1.003 | 1.002 | 1.001 | 1.001 | 1.000 |
| 4100 | 1.003 | 1.003 | 1.002 | 1.001 | 1.001 | 1.000 |

## FIG.2

Etat plein SoE = 1

E15

E16a

Décharge d'une énergie $E_D$
Sous conditions $Y_D$
Calcul de l'énergie disponible

Charge complète à $X_{E16}$ ou $X_{nom}$ et mesure
de l'énergie chargée $E_{E16}$
Ou
Décharge complète à $Y_{E16}$ ou $Y_{nom}$ et
mesure de l'énergie déchargée $E_{E16}$

A1

E16b  Remise à l'état plein SoE = 1

Détermination de l'état d'énergie initial
et remise à l'état plein SoE = 1

E17

FIG.3

## FIG.4

Etat vide SoE = 0

E25

E26a

charge d'une énergie Ec
Sous conditions $X_c$
Calcul de l'énergie recevable

Décharge complète à $Y_{nom}$ ou $Y_{E26}$ et mesure
de l'énergie déchargée $E_{E26}$
Ou
Charge complète à $X_{nom}$ ou $X_{E26}$ et mesure de
l'énergie chargée $E_{E26}$

A2

E26b

Remise à l'état vide SoE = 0

Détermination de l'état d'énergie initial

E27

## FIG.5

# FIG.6

FIG.7

Etat vide SOE = 0

FIG.8 — E20

Choix de la puissance de charge $P_{cj}$ — E21

Charge Complète à $P_{cj}$, mesure de l'énergie

Décharge nominale complète $P_{nomd}$, mesure de l'énergie — E22a

Détermination de l'état final de charge $SoE_{fc}$ — E23

Choix de l'énergie à charger $E_{ci}$ — E24

Algorithme A2

Nombre d'états initiaux atteints ? — E28

Nombre de puissance de charge atteints ? — E29

Non

Non

FIG.9

E10

E11

E12a

E13

E14

E18

E19

Etat plein SOE = 1

Choix de la puissance de décharge $P_{dj}$

Décharge complète à $P_{dj}$, mesure de l'énergie

Charge nominale complète $P_{nomc}$, mesure de l'énergie

Détermination de l'état final de décharge $SoE_{fd}$

Choix de l'énergie à décharger $E_{di}$

Algorithme A1

Nombre d'états initiaux atteints ?

Nombre de puissance de charge atteints ?

Non

Non

# FIG.10

## FIG.11

**RÉFÉRENCES CITÉES DANS LA DESCRIPTION**

**Documents brevets cités dans la description**

- WO 2011000872 A

- WO 2013175005 A